# EUROPEAN PATENT APPLICATION

(11) **EP 4 596 187 A1**
(43) Date of publication of application: **06.08.2025**
(21) Application number: 23871820.9
(22) Date of filing: 08.09.2023
(51) Int. Cl.: B25J 19/00, H02K 41/06, H02K 7/116, H01L 21/677

(54) **ACTUATOR AND WORKPIECE DELIVERY ROBOT EQUIPPED WITH SAME**

(30) Priority: 30.09.2022 WO PCT/JP2022/036639
(71) Applicant: Rorze Corporation, Fukuyama-shi, Hiroshima 720-2104 (JP)
(72) Inventor: SAKIYA, Fumio, Fukuyama-shi, Hiroshima 720-2104 (JP)
(74) Representative: Kramer Barske Schmidtchen Patentanwälte PartG mbB
(86) International application number: PCT/JP2023/032823
(87) International publication number: WO 2024/070583

(57) **Abstract**

The present invention provides a high-precision actuator which has a small vertical size and in which backlash is suppressed. An actuator 1 comprises a reduction gear section and a motor section. In the reduction gear section, an annular fixed gear 5 and an annular output gear 4 are arranged in parallel to each other, and a oscillating gear 6 is disposed between the fixed gear 5 and the output gear 4 in a state of being inclined with respect to the fixed gear 5 and the output gear 4. The fixed gear 5 and the oscillating gear 6 are configured so as to mesh with each other at a first position, and the oscillating gear 6 and the output gear 4 are configured so as to mesh with each other at a second position. Magnetic force, generated by an electromagnet 8 in the motor section and a permanent magnet 7 fixed to the outer circumference of the oscillating gear, acts in a meshing pressing direction on both sides at the first position and the second position so as to suppress backlash.

## Description

### TECHNICAL FIELD

The present invention relates to an actuator that includes a motor section and a reduction gear section, and further relates to a workpiece transfer robot that includes the actuator.

### BACKGROUND ART

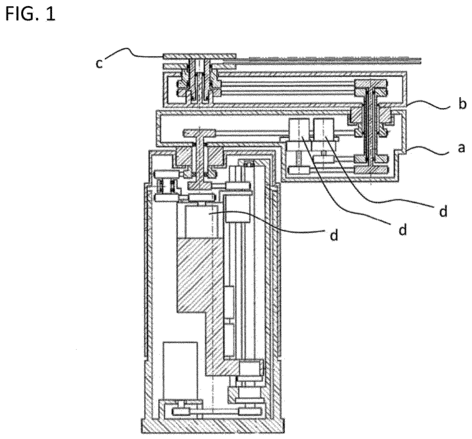

In a conveyance apparatus that transports a substrate such as a semiconductor wafer a clean transfer robot provided with a horizontal multi-joint arm is mainly mounted, and is used to transport the substrate between a container in which the substrate is accommodated and a processing apparatus. FIG. 1 is a cross-sectional view showing a structure of a conventional clean transfer robot. The horizontal articulated arm of the transfer robot has two upper and lower stages of arms a, b and a finger c rotatably connected to each other, and each of the arms a, b and the finger c is configured to be driven by an individual actuator d. The technology shown in Patent Document 1 is known as such a clean transfer robot.

A motor section of actuators in robot joints often uses electric motors, which are easy to control. The electric motors need to have a small diameter so that they can be installed in the limited space of the robot joints. However, as the diameter becomes smaller, the torque becomes low, so a reduction gear section is attached to increase the torque with a large reduction ratio.

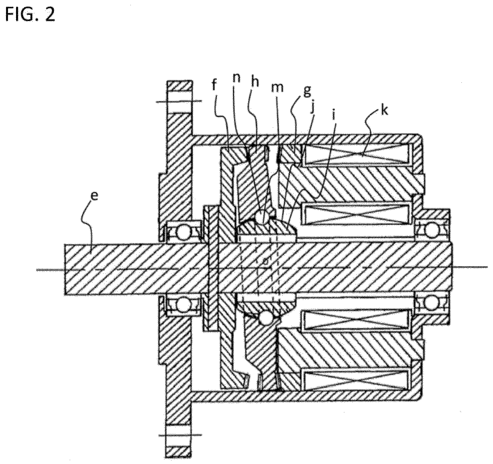

A differential gear reduction mechanism is known as a reduction gear in which a reduction ratio per tooth number of a gear is increased. For example, according to Patent Documents 2 and 3, an actuator (title of the invention "motor") provided with a differential gear mechanism as a reduction gear section is disclosed. The reduction gear is a reduction gear that utilizes precession and nutation motion among reduction gears having a differential gear mechanism. A cross-sectional view (FIG. 1) disclosed in both Patent Documents 2 and 3 is transferred to FIG. 2. The reduction gear is provided with a oscillating gear h having tooth surfaces on both surfaces between an output gear f rotating together with an output shaft e and a fixed gear g fixed to a main body, and a rotor is configured to maintain a state in which the oscillating gear h is always inclined at a constant angle with respect to the output shaft e, while each tooth of the oscillating gear h is engaged with the output gear f and the fixed gear g. The oscillating gear h is made of magnetic material, and six coils k are arranged at equal intervals on the side of the oscillating gear h where the fixed gear g is arranged, as a driving source for rocking the oscillating gear.

When one of the six coils k is energized, the oscillating gear h is attracted by the magnetism generated by the coil k, and then sequentially energized to the next coil k, whereby an inclination direction of the oscillating gear h is rotated by being attracted to the energized coil k. Accordingly, a position where teeth of the fixed gear g and teeth of the oscillating gear h mesh is also displaced in the rotation direction. A predetermined difference in the number of teeth between the fixed gear g and the oscillating gear h is provided, which causes a rotational displacement between the fixed gear g and the oscillating gear h. Similarly, a predetermined difference is set to the number of teeth between the oscillating gear h and the output gear f, which cause a displacement between the oscillating gear h and the output gear f. Thus, the large reduction ratio is obtained.

Patent Document 4 discloses an actuator (title of the invention "ACTUATOR AND ARTICULATED ROBOT ARM") provided with a differential gear mechanism as a reduction gear section. This reduction gear is also a reduction gear that utilizes precession and chapter motion.

### RELATED ART DOCUMENTS

### PATENT DOCUMENTS

Patent Document 1: Japanese Unexamined Patent Application Publication No. 2012-161858
Patent Document 2: Japanese Examined Patent Publication No. 06-005981
Patent Document 3: Japanese Unexamined Patent Application Publication No. 61-22752
Patent Document 4: Japanese Unexamined Patent Application Publication No. 2015-142454

### DISCLOSURE OF THE INVENTION

### PROBLEMS TO BE SOLVED BY THE INVENTION

A gap (backlash) is necessarily set up between the gears to ensure smooth operation of the gears in the reduction gear, and this backlash becomes an obstacle to highly accurate control of the rotation angle.

In the technology of Patent Documents 2 and 3, a ball groove j is provided in a spherical outer shape portion j of a rotor i, and the oscillating motion of the oscillating gear h is regulated by the ball groove j, but a gap is required to physically operation. When the oscillating gear h is attracted to the fixed gear g side by energizing the coil arranged below the oscillating gear h, the oscillating gear g(h) descends by the gap, and the backlash of the output gear f and the oscillating gear g(h) is enlarged. On the other hand, if the oscillating gear h is regulated without any clearance by the ball groove j, the problem of the gap that allows the physical operation remains between the oscillating gear h and the fixed gear g, and between the output gear f and the oscillating gear g(h). The robot joints require high-precision rotational angle control, and backlash impedes this.

In the technology of Patent Document 4, an inclination direction of the oscillating gear is not restricted by the meshing of the teeth, but by an electromagnetic force that a stator magnetic circuit exerts on a rotor magnetic circuit. However, since a salient pole of a stator yoke having an E-shaped cross section and a yoke of the rotor magnetic circuit face each other in the radial direction (Patent Document 4, column 0048), an attractive action of the electromagnetic force is in the radial direction.

The present invention aims to enable the high-precision rotational angle control by suppressing backlash in an actuator in which a reduction gear is attached to a motor section. In addition, the present invention aims to suppress the vertical dimension of the actuator.

### MEANS OF SOLVING THE PROBLEMS

In order to solve the above problem, the present invention is configured such that a permanent magnet is arranged on the outer side of the oscillating gear around a central axis line, and magnetic poles of an electromagnet are arranged above and below the permanent magnet, and a magnetic force acts in the central axis line direction. A magnetic attraction force acts in a direction that presses the oscillating gear against the teeth of the fixed gear at a first position, and acts in a direction that presses a second teeth of the oscillating gear against the teeth of the output gear at a second position which has turned half a turn. A posture of the oscillating gear is constrained by the first position and the second position, where they are pressed by the magnetic attraction force, so that backlash is extremely suppressed. Since the permanent magnet is attached to the outer circumferential side of the oscillating gear, force pressing the inner circumferential side of the oscillating gear and the teeth of the fixed gear, and force pressing the teeth of the oscillating gear and the teeth of the output gear, act more strongly.

In order to solve the above problem, the actuator of the present invention is configured so as to suppress backlash by using magnetic force of an electromagnet of a motor section. One embodiment of the actuator of the present invention is characterized by including a housing supporting an output shaft in a vertical direction as an axial direction, an output gear rotating together with the output shaft, a fixed gear fixed to the housing and provided facing the output gear, a oscillating gear arranged between the output gear and the fixed gear, wherein first teeth on the side faced to the fixed gear are meshed with the fixed gear and second teeth on the side faced to the output gear are meshed with the output gear, a permanent magnet fixed concentrically to the oscillating gear on the outer circumferential side of the oscillating gear, and a plurality of electromagnets fixed on the housing concentrically to the output shaft and having an upper magnetic pole piece and a lower magnetic pole piece facing each other in the vertical direction on an upper surface and a lower surface of the permanent magnet so as not to contact the permanent magnet which oscillates due to oscillating motion of the oscillating gear, wherein the upper magnetic pole piece and the lower magnetic pole piece and the upper surface and the lower surface of the permanent magnet form a magnetic gap in the vertical direction, and wherein the lower magnetic pole piece and the lower surface of the permanent magnet as well as the upper pole piece and the upper surface of the permanent magnet act in a direction to press the first teeth of the oscillating gear against the teeth of the fixed gear in a first position and in a direction to press the second teeth of the oscillating gear against the teeth of the output gear in a second position which has turned half a turn.

With the above configuration, the magnetic force generated by the electromagnets in the motor section causes the teeth of the oscillating gear to come into contact with the teeth of the fixed gear and the output gear on both the normal rotation side and the reverse rotation side, resulting in extremely suppressed backlash. In addition, since the fixed gear, the oscillating gear, and the output gear are arranged on the outer circumference of the output shaft, and the permanent magnet is placed on the outer circumferential side of the oscillating gear around the central axis line, the force pressing the inner circumferential side of the oscillating gear and the teeth of the fixed gear, and the force pressing the teeth of the oscillating gear and the teeth of the output gear can be more strongly applied. The vertical dimension of the actuator can be suppressed by positioning the electromagnets horizontally from where the permanent magnet is located and on the outer circumferential side of the permanent magnet around the central axis line.

It is desirable that electromagnets arranged at positions facing 180° in a plan view are configured to be provided with the same phase current and direct opposite polarities to the oscillating gear. With the above configuration, the oscillating gear to which the permanent magnet is attached can be urged in a predetermined direction at a position facing 180°. In case a different magnetic pole is provided between the upper surface and the lower surface of the permanent magnet, the magnetic pole may be formed in a substantially U-shape including an upper magnetic pole piece and a lower magnetic pole piece, so that the permanent magnet may be sandwiched between the upper magnetic pole piece and the lower magnetic pole piece. According to this, the permanent magnet can be efficiently urged in the vertical direction.

The actuator according to the present invention can be used to rotationally drive a plurality of arms and fingers of a workpiece transfer robot including an arm body, in which a plurality of arms are rotatably coupled about the central axis line, and a finger rotatably attached to the tip of the arm body. Accordingly, the vertical dimension of each arm of the workpiece transfer robot can be suppressed, and each arm can be reduced in weight. Further, since the permanent magnet for driving the output shaft can be arranged in an outer circumferential direction of the output shaft, the output shaft can be formed into a hollow cylindrical shape. This allows electrical wiring and piping required for the arm operation to be laid through the internal space of the output shaft.

In addition, the actuator of the present invention is configured such that a oscillating gear is disposed outside the output shaft, a permanent magnet is disposed outside the oscillating gear, and an electromagnet for driving the permanent magnet is arranged outside the permanent magnet. The oscillating gear is arranged in an inclined position such that it meshes with the fixed gear in the first position and the output gear in the second position. Furthermore, the magnetic poles of the electromagnet are arranged at equal intervals on the circumference centered on the central axis line of the output shaft, and the current is supplied from the control unit such that the polarity is opposite between the magnetic poles arranged at positions rotated by 180° about the central axis line. According to this, due to the action of the permanent magnet and the magnetic pole, the oscillating gear is urged in the direction of meshing with the fixed gear at the first position, and is urged in the direction of meshing with the output gear at the second position rotated by 180°. Further, by configuring the magnetic poles placed on both sides of the magnetic poles facing the first position and the second position, respectively, to also generate magnetic forces of the same polarity as the magnetic poles facing the first position and the second position, a stronger urging force can be applied to the oscillating gear.

In addition, the actuator of the present invention is characterized in that the actuator includes a permanent magnet arranged on the outer circumference of a oscillating gear with one magnetic pole facing outward from the center point of the oscillating gear, and a plurality of electromagnets fixed to a housing concentrically on the output shaft surrounding the outer circumference of the oscillating gear, and are arranged so as to sandwich the permanent magnet with a gap allowing the oscillating gear to oscillating, in which an upper magnetic pole piece which becomes one magnetic pole is placed above the magnetic pole of the permanent magnet and a lower magnetic pole piece which becomes the other magnetic pole is placed below the permanent magnet, and the upper magnetic pole piece and lower magnetic pole piece of each electromagnet have different magnetic poles, and a magnetic attraction force generated by the permanent magnet sandwiched between them having one polarity acts in a direction pressing first teeth of the oscillating gear against teeth of the fixed gear at a first position, and acts in a direction pressing second teeth of the oscillating gear against teeth of the output gear at a second position which has turned half a turn.

In case the adjacent permanent magnets are arranged so as to have opposite polarities in the plurality of permanent magnets arranged around the oscillating gear, the number of the first teeth of the oscillating gear and the number of teeth of the fixed gear are made the same.

### EFFECT OF INVENTION

According to the present invention, by the magnetic force generated by the electromagnet of the motor section, the gear of the oscillating gear is in contact with the gears of the fixed gear and the output gear both on the normal rotation side and the reverse rotation side, and the backlash can be extremely suppressed. In addition, a large driving force can be obtained at a large attenuation ratio while suppressing the vertical dimension of the actuator.

### BRIEF DESCRIPTION OF THE DRAWINGS

FIG. 1 is a view showing a prior art.
FIG. 2 is a view showing a prior art (FIG. 1 of Patent Literature 2 and 3).
FIG. 3 is a view illustrating a first embodiment of the present invention.
FIG. 4 is a view illustrating an engagement state of a oscillating gear according to the present invention.
FIG. 5 is a view illustrating a magnetic force generated in a magnetic pole of the present invention.
FIG. 6 is a view illustrating the action of an actuator of the present invention.
FIG. 7 is a view illustrating a magnetic force generated in a magnetic pole included in the actuator of the present invention.
FIG. 8 is a view illustrating the action of the actuator of the present invention.
FIG. 9 is a view illustrating a second embodiment of the present invention.
FIG. 10 is a view illustrating a magnetic force generated in a magnetic pole included in the actuator of the present invention.
FIG. 11 is a view illustrating the action of the actuator of the present invention.
FIG. 12 is a view illustrating a magnetic force generated in a magnetic pole included in the actuator of the present invention.
FIG. 13 is a view illustrating the action of the actuator of the present invention.
FIG. 14 is a view illustrating a configuration of a motor section included in the actuator of the present invention.
FIG. 15 is a view illustrating a third embodiment of the present invention.
FIG. 16 is a view illustrating the third embodiment of the present invention.
FIG. 17 is a view illustrating another example of the third embodiment of the present invention.

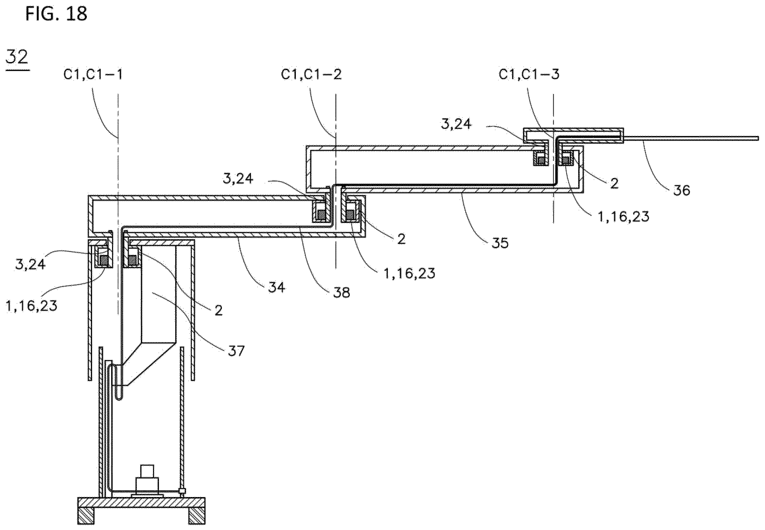

FIG. 18 is a view showing a workpiece transfer robot according to the present invention.

### MODE FOR CARRYING OUT THE INVENTION

Hereinafter, each embodiment of the present invention will be described with reference to the drawings. In the present invention, a oscillating gear is supported at two positions of a contact position with a fixed gear and a contact position with an output gear. These two contact positions are located half a turn around an output shaft. Then, at each contact position, the oscillating gear is urged in a direction in which it is pressed against the fixed gear and the output gear by the magnetic force generated by an electromagnet in a motor section. Therefore, in an engagement position, both surfaces on the normal rotation side and the reverse rotation side of the teeth of the oscillating gear are in contact with the teeth of the fixed gear and the output gear, and backlash is extremely suppressed.

In the present description, "upper" and "lower" refer to one side along the axial direction of the output shaft, and the other side along the axial direction of the output shaft, and not refer to upper and lower sides in the direction of gravity.

### (First Embodiment/Overall Description)

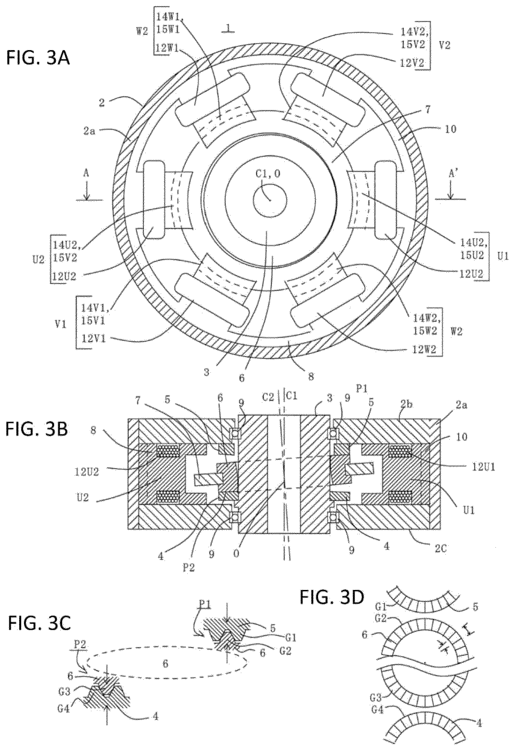

FIG. 3A is a plane cross-section view of an actuator 1 according to the first embodiment of the present invention, and FIG. 3B is a cross-section view in a cutting line A-A' shown in FIG. 3A. FIG. 3C shows a contact state of teeth of an output gear 4 and a oscillating gear 6, and teeth of the oscillating gear 6 and a fixed gear 5, and FIG. 3D shows the shape of the teeth viewed from above. The actuator 1 of the present embodiment includes at least a housing 2, an output shaft 3 rotatably attached to the housing 2 through a bearing 9, an annular output gear 4 fixed to the output shaft 3, an annular fixed gear 5 fixed to the housing 2, a oscillating gear located between the fixed gear 5 and the output shaft 4, an annular permanent magnet 7 fixed to the outer circumference of the oscillating gear 6, and an electromagnet 8 fixed to the housing 2 and arranged on the outer circumference of the annular permanent magnet 7. In addition, the output shaft 3 of the present embodiment is formed of a metal such as iron and aluminum having a hollow substantially cylindrical shape.

The housing 2 includes a housing body 2a formed in a substantially cylindrical shape, a disk-shaped upper housing 2b covering an upper portion of the housing body 2a, and a disk-shaped lower housing 2c covering a lower portion of the housing body 2a. A circular opening is provided in the center of the upper housing 2b and the lower housing 2c, and the upper and lower ends of the output shaft 3 rotatably supported by the housing 2 are positioned so as to protrude from the housing 2 in the upper and lower openings. According to this, the output shaft 3 of the present embodiment is rotatable with respect to the housing 2 with the axis line C1 as the center of rotation. Further, the upper and lower spaces partitioned by the housing 2 communicate with each other by the hollow portion of the output shaft 3.

The actuator 1 according to the present embodiment includes a motor section that is a drive source that rotationally drives the output shaft 3, and a reduction gear section that decelerates the driving force of a motor and transmits it to the output shaft 3.

### (Reduction Gear Section)

The reduction gear section will be described. The output gear 4 is an annular member in which a hole is formed in the center, and is fixed to the output shaft 3 so that its center coincides with the axis line C1. The fixed gear 5 is an annular member in which a hole through which the output shaft 3 can pass is formed in the center, and is fixed to the housing 2 such that its center coincides with the axis line C1. The output gear 4 and the fixed gear 5 are fixed so as to be in a posture perpendicular to the axis line C1 as viewed in the drawing. A oscillating gear 6 is disposed between the output gear 4 and the fixed gear 5. The oscillating gear 6 is an annular member formed of a metal such as iron and aluminum, and is arranged in a space between the output gear 4 and the fixed gear 5.

An annular permanent magnet 7 is concentrically fixed to the outer circumference of the oscillating gear 6, and the oscillating gear 6 and the annular permanent magnet 7 operate integrally. Besides, the annular permanent magnet 7 of the present embodiment is magnetized so that its upper surface has an N pole and the lower surface has an S pole as viewed in the drawing. The oscillating gear 6 is arranged so as to be rotatable about an inclined central axis line C2 as a rotation center. The inclined central axis line C2 is an axis that oscillates at a predetermined angle with respect to the axis line C1.

The inclination angle of the inclined central axis line C2 is maintained by being supported at two points: the contact position between the oscillating gear 6 and the fixed gear 5, and the contact position between the oscillating gear 6 and the output gear 4. Here, a position where the fixed gear 5 and the oscillating gear 6 mesh with each other is defined as a first position P1, and a position where the oscillating gear 6 and the output gear 4 mesh with each other (the position half a turn from the first position P1) is defined as a second position P2.

The oscillating gear 6 is in a "floating" state with respect to the output shaft 3. The "floating" state means that the oscillating gear 6 is supported at two points, the first position P1 and the second position P2, and that the output shaft 3 does not interfere with the support at the two positions.

The oscillating gear 6 is an annular ring, the output shaft 3 penetrates the center of the oscillating gear 6 with a gap, and the oscillating gear 6 is prevented from separating in the radial direction.

On the surface of the fixed gear 5 facing the oscillating gear 6, teeth G1 are formed radially in the radial direction with the axis line C1. On the surface of the oscillating gear 6 facing the fixed gear 5, teeth G2 are formed radially in the radial direction with the inclined central axis line C2. A plurality of teeth G3 are also formed radially in the radial direction with the inclined central axis line C2 on the surface of the oscillating gear 6 facing the output gear 4. A plurality of teeth G4 are also formed radially in the radial direction with the axis line C1 on the surface of the output gear 4 facing the oscillating gear 6.

As a configuration required for maintaining the angle of the inclined central axis line C2, first, the oscillating gear 6 is formed so that the teeth G1 to G4 mesh with each other in a state of being inclined at the angle of the inclined central axis line C2 relative to the horizontally arranged output gear 4 and fixed gear 5.

When the teeth G2 formed on the upper surface side of the oscillating gear 6 and the teeth G1 formed on the fixed gear 5 mesh with each other, and when the teeth G3 formed on the lower surface side of the oscillating gear 6 and the teeth G4 formed on the output gear 4 mesh with each other, the oscillating gear 6 inclines relative to the fixed gear 5 and the output gear 4 at an angle equal to the inclination angle of the inclined central axis line C2.

The position where the teeth G2 of the oscillating gear 6 that are located around the highest point mesh with the teeth G1 formed on the fixed gear 5 is a first position P1, and the position where the teeth G3 around the lowest point of the plurality of teeth G3 of the oscillating gear 6 mesh with the teeth G 4 formed on the output gear 4 is a second position P2. At this time, the axis line C1 and the inclined central axis line C2 intersect at the center point O.

The teeth on the tooth surfaces formed on each of the gears 4, 5, and 6 are formed radially in the radial direction, and the pitch of each tooth gradually increases as it moves radially from the center of each gear (see FIG. 3D). Further, the depth of each of the teeth G1 to G4 formed on the fixed gear 5, the output gear 4, and the oscillating gear 6 may be formed so as to gradually increase in the radial direction from the axis line C1 and the inclined central axis line C2 of each of the gears 4, 5 and 6. According to this, the teeth G1 to G4 mesh with each other through magnetic force, and an automatic centering effect is applied to each gear 4, 5 and 6, so that the positional relationship between the fixed gear 5 and the oscillating gear 6, and the positional relationship between the output gear 4 and the oscillating gear 6, do not shift in the direction of rotation. Furthermore, since the automatic centering action always maintains the meshing state of both sides of forward rotation and reverse rotation of the gears, it is possible to suppress the occurrence of backlash.

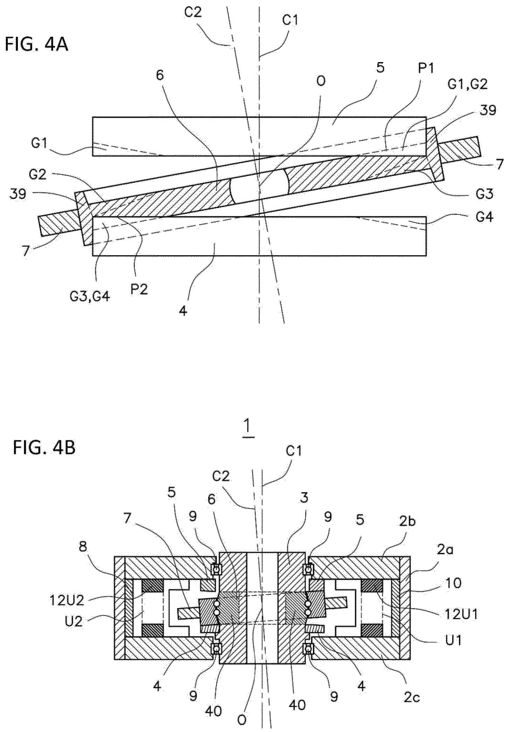

Besides, in the present embodiment, an annular movement restricting protrusion 39 can be formed on the outer circumference of the oscillating gear 6 to prevent displacement of the oscillating gear 6 in the radial direction with respect to the output gear 4 and the fixed gear 5. See FIG. 4A. At the first position P1 where the oscillating gear 6 and the fixed gear 5 mesh with each other, the movement restricting protrusion 39 restricts the oscillating gear 6 from moving leftward as viewed in the drawing, and at the second position P2 where the oscillating gear 6 and the output gear 4 mesh with each other, which is a position rotated 180° from the first position P1, the oscillating gear 6 restricts the oscillating gear 6 from moving rightward as viewed in the drawing. That is, the movement restricting protrusion 39 can restrict the oscillating gear 6 from moving in the radial direction around the inclined central axis line C2. This configuration prevents the oscillating gear 6 from deviating due to a large impact applied during transportation, installation, and the like of the actuator 1. A means for restricting the movement of the oscillating gear 6 in the radial direction is not limited to the movement restricting protrusion 39, but may be a form in which the oscillating gear 6 is supported by the output shaft 3 through a bearing 40 so as to be freely oscillating. See FIG. 4B. As well-known bearings 40, for example, a spherical sliding bearing, an automatic aligning bearing, a ball joint, and the like can be used. It is desirable that such movement restricting protrusion 39 and bearing 40 do not interfere as much as possible with the support at two points by the first position P1 and the second position P2.

### (Motor Section)

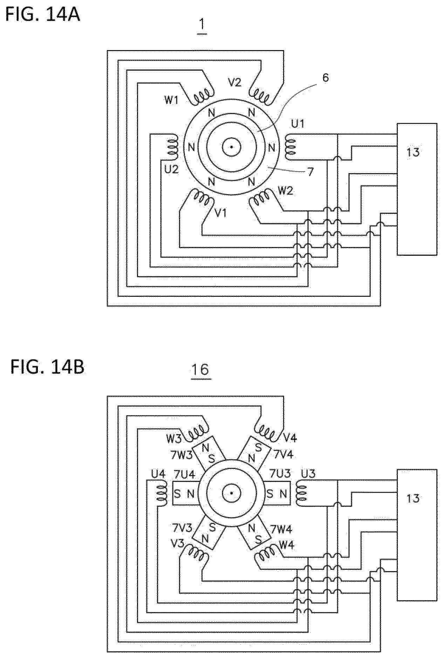

Next, a motor section that oscillates the oscillating gear 6 will be described. FIG. 14A is a view showing the configuration of a motor section of the present embodiment. The motor section of the present embodiment includes an annular permanent magnet 7 fixed to the outer circumferential edge of the oscillating gear 6, and an electromagnet 8 disposed outside the permanent magnet 7. The permanent magnet 7 is arranged such that the entire surface on the upper surface side is an N pole and the entire surface on the lower surface side is an S pole. The permanent magnet 7 does not have to be annular, and may be a plurality of magnets with their magnetic poles oriented in the vertical direction attached radially to the oscillating gear 6. The electromagnet 8 in the present embodiment is a member formed from a magnetic material such as iron, and is composed of a ring 10 formed in an annular shape centered on the axis line C1, and magnetic poles U1, U2, V1, V2, W1, and W2 that are equally spaced concentrically about the axis line C1. Coils 12U1, 12U2, 12V1, 12V2, 12W1, and 12W2 are wound on the outer circumferences of the magnetic poles U1, U2, V1, V2, W1, and W2. One magnetic pole U1, U2, V1, V2, W1, and W2 of the electromagnet 8 protrude from the ring 10 toward the oscillating gear 6, and surround the outer circumference of the oscillating gear 6. The magnetic poles U1, U2, V1, V2, W1, and W2 are configured from magnetic pole pieces 14U1, 14U2, 14V1, 14V2, 14W1, 14W2, 15U1, 15U2, 15V1, 15V2, 15W1, and 15W2 whose tips are cut into a U-shape and vertically branched. Further, the upper magnetic pole pieces 14U1, 14U2, 14V1, 14V2, 14W1, and 14W2, and the lower magnetic pole pieces 15U1, 15U2, 15V1, 15V2, 15W1, and 15W2 facing each other are arranged at intervals so as to sandwich the permanent magnet 7 fixed to the oscillating gear 6. Each of the coils 12U1, 12U2, 12V1, 12V2, 12W1, and 12W2 is connected to the control unit 13, and when the control unit 13 sequentially applies to these coils 12U1, 12U2, 12V1, 12V2, 12W1, and 12W2, the magnetic fields generated in each of the magnetic poles U1, U2, V1, V2, W1, and W2 change sequentially, causing the permanent magnet 7 and the oscillating gear 6 to rock and move.

### (Rotation of Upper and Lower Attraction Positions/Generation of Rotating Magnetic Field)

The upper magnetic pole pieces 14U1, 14U2, 14V1, 14V2, 14W1, and 14W2 rotate the positions at which they attract/repel the permanent magnet 7 around the axis line C1. Further, the positions at which the lower magnetic pole pieces 15U1, 15U2, 15V1, 15V2, 15W1, and 15W2 attract/repel the permanent magnet 7 also rotate so as to be deviated by 180° from the upper attracting position. In the present embodiment, in order to realize such rotation of the attraction/repulsion positions, the magnetic poles U1, U2, V1, V2, W1 and W2 are arranged to generate a rotating magnetic field. The magnetic poles U1, U2, V1, V2, W1, and W2 are arranged concentrically at intervals of 60° around the axis line C1. Further, the coils 12U1, 12U2, 12V1, 12V2, 12W1, and 12W2 of the six magnetic poles U1, U2, V1, V2, W1, and W2 are wound around the opposing magnetic poles U1, U2, V1, V2, W1, and W2, respectively, so that the direction of the magnetic field is opposite when current is applied. For example, in FIG. 3A, the magnetic pole U2 is disposed at a position 180° opposite to the magnetic pole U1 as viewed in the drawing, the magnetic pole W2 is disposed at a position rotated 60° clockwise from the position of the magnetic pole U1, the magnetic pole W1 is disposed at a position 180° opposite to the magnetic pole W2, and the magnetic pole V1 is disposed at a position rotated 60° clockwise from the position of the magnetic pole W2, and the magnetic pole V2 is disposed at a position 180° opposite to the magnetic pole V1.

The permanent magnet 7, the upper magnetic pole pieces 14U1, 14U2, 14V1, 14V2, 14W1, and 14W2, and the lower magnetic pole pieces 15U1, 15U2, 15V1, 15V2, 15W1, and 15W2 are attracted to each other in the direction of the central axis line C1. The direction of the magnetic attractive force is a direction that presses the meshing of the fixed gear 5 and the oscillating gear 6 against each other, and a direction that presses the meshing of the oscillating gear 6 and the output gear 4 against each other (see FIG. 3C). The teeth G2 of the oscillating gear 6 and the teeth G1 of the fixed gear 5, and the teeth G3 of the oscillating gear 6 and the teeth G4 of the output gear 4 are vertically pressed against each other at positions shifted by half a circumference due to the magnetic attractive force. That is, since contact is maintained between the surfaces on both the normal rotation side/reverse rotation side of the teeth G2 and G3 of the oscillating gear 6 and the surfaces on both the normal rotation side/reverse rotation side of the teeth G1 of the fixed gear 5 and the teeth G4 of the output gear 4, there will be no backlash. Since the permanent magnet 7 is attached to the outer circumferential side of the oscillating gear 6, the force pressing the teeth G2 of the oscillating gear 6, the teeth G3 of the fixed gear 5, the teeth G3 of the oscillating gear 6, and the teeth G4 of the output gear 4 on the inner circumferential side acts more strongly.

Extremely narrow magnetic gaps between the upper surface of the permanent magnet 7 and the upper magnetic pole pieces 14U1, 14U2, 14V1, 14V2, 14W1, and 14W2 and between the lower surface of the permanent magnet 7 and the lower magnetic pole pieces 15U1, 15U2, 15V1, 15V2, 15W1, and 15W2 are formed, wherein the gaps are located on a diameter connecting the point where the teeth G2 of the oscillating gear 6 is pressed against the teeth G1 of the fixed gear 5 and the point where the teeth G3 of the oscillating gear 6 is pressed against the teeth G4 of the output gear 4 , and wherein the center of the diameter is on the central axis line C1. Conversely, due to the meshing of the teeth G2 of the oscillating gear 6 with the teeth G1 of the fixed gear 5, and the meshing of the teeth G3 of the oscillating gear 6 with the teeth G4 of the output gear 4, the permanent magnet 7, which oscillates due to the rock of the oscillating gear 6, is maintained so as not to come into contact with the upper magnetic pole species and the lower magnetic pole pieces that face its upper and lower surfaces in the vertical direction, respectively.

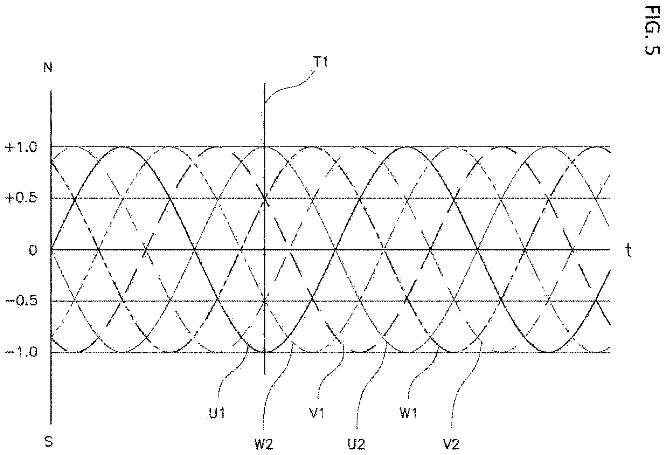

Next, the operation of the actuator 1 of the present embodiment will be described. In the actuator 1 of the present embodiment, a sine wave current whose magnitude and direction change periodically over time is supplied from the control unit 13. Further, the control unit 13 supplies three-phase currents, and a current of each phase is supplied to the magnetic pole U1 and the magnetic pole U2, the magnetic pole V1 and the magnetic pole V2, and the magnetic pole W1 and the magnetic pole W 2, which are arranged at positions opposite each other by 180°. Current generated in a sine wave waveform is supplied from the control unit 13 to the coils 12U1, 12U2, 12V1, 12V2, 12W1, and 12W2. FIG. 5 is a graph showing changes in magnetic force generated in the magnetic poles U1, U2, V1, V2, W1, and W2 when the sine wave current is applied to each of the magnetic poles U1, U2, V1, V2, W1, and W2. The horizontal axis of this graph represents time, and the vertical axis represents the magnitude and polarity of the magnetic force. The greater the polarity value is above 0, the stronger the magnetic force of the N pole, and the greater the negative value is, the stronger the magnetic force of the S pole. Further, the time point indicated by the vertical line T1 in FIG. 5 represents the polarity and strength of magnetic force of each magnetic pole at the rotational position of the oscillating gear 6 and the permanent magnet 7 shown in FIG. 3. Here, the control unit 13 supplies the same phase current to the magnetic poles U1 and U2, supplies the same phase current to the magnetic poles V1 and V2, and supplies the same phase current to the magnetic poles W1 and W2, among the three-phase currents. The coil 12U1 and the coil 12U2, the coil 12V1 and the coil 12V2, and the coil 12W1 and the coil 12W2, which are arranged at positions opposite to each other by 180°, are wound so that the magnetic field directions are opposite when current is applied, so that the magnetic pole U1 and the magnetic pole U2, the magnetic pole V1 and the magnetic pole V2, and the magnetic pole W1 and the magnetic pole W2 have opposite polarities to each other while being supplied with the same current, respectively. That is, the motor section provided by the actuator 1 in the present embodiment has six-phase coils.

### (Action on Permanent Magnet by Magnetic Field)

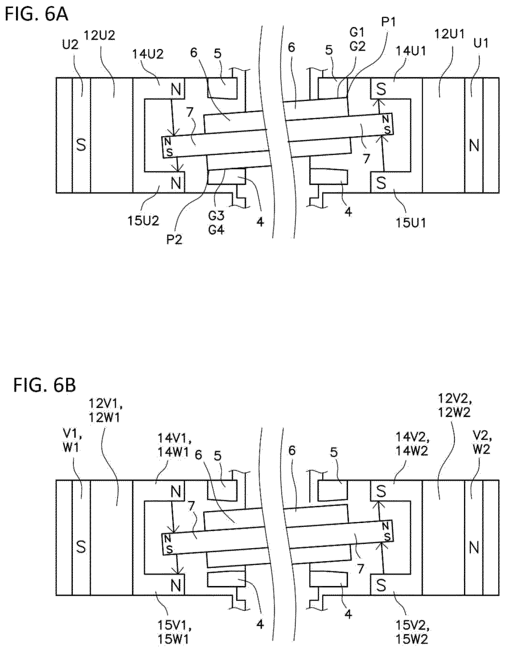

At the time point T1 shown in FIG. 5, the portion of the magnetic pole U1 facing the permanent magnet 7 takes a strong S polarity of -1.0. Further, the portion of the magnetic pole U2 facing the permanent magnet 7 takes a strong N polarity of +1.0. The permanent magnet 7 is arranged so that the upper surface side takes an N polarity and the lower surface side takes an S polarity, so that the magnetic attraction force is generated between the upper N pole of the permanent magnet 7 and the upper magnetic pole piece 14 U1 (S pole) of the magnetic pole U1 at the position of the permanent magnet 7 facing the magnetic pole U1, and the magnetic repulsive force is generated between the lower S pole of the permanent magnet 7 and the lower magnetic pole piece 15U1 (S pole) of the magnetic pole U1. See FIG. 6A. At this time point T1, the magnetic poles V2 and W2 arranged on both sides of the magnetic pole U1 take an S polarity of -0.5, which is smaller than that of the magnetic poles U1, so that the magnetic attraction force is generated between the upper N pole of the permanent magnet 7 and the upper magnetic pole pieces 14V2 and 14W2 (S pole) of the magnetic poles V2 and W2, and the magnetic repulsive force is generated between the lower S pole of the permanent magnet 7 and the lower magnetic pole pieces 15V2 and 15W2 (S pole) of the magnetic poles V2 and W2. See FIG. 6B. According to this action, at the position of the permanent magnet 7 corresponding to the magnetic pole U1, the strong magnetic force of the magnetic pole U1 urges the permanent magnet 7 upward as viewed in the drawing, and further, to assist the urging force of the magnetic pole U1, the magnetic force weaker than that of the magnetic pole U1, which is generated in the magnetic poles V2 and W2, urges the permanent magnet 7 upward as viewed in the drawing. According to this action, at the first position P1, the oscillating gear 6 is urged in the direction meshing with the fixed gear 5 by the magnetic force, and at the second position P2, the oscillating gear 6 is urged in the direction meshing with the output gear 4 by the magnetic force.

In addition, at the time point T1, the portion of the magnetic pole U2 facing the permanent magnet 7 takes a strong N polarity of +1.0. The permanent magnet 7 is magnetized so that the upper side takes an N polarity and the lower side takes an S polarity, so that the magnetic repulsive force is generated between the upper N pole of the permanent magnet 7 and the upper pole piece 14U2 (N pole) of the magnetic pole U2, and the magnetic attraction force is generated between the lower S pole of the permanent magnet 7 and the lower pole piece 15U2 (N pole) of the magnetic pole U2. See FIG. 6A. At this time point T1, the magnetic poles V1 and W1 arranged on both sides of the magnetic pole U2 take an N polarity of +0.5, which is smaller than that of the magnetic pole U2, so that the magnetic repulsive force is generated between the upper N pole of the permanent magnet 7 and the upper magnetic pole pieces 14V1 and 14W1 (N pole) of the magnetic poles V1 and W1, and the magnetic attraction force is generated between the lower S pole of the permanent magnet 7 and the lower magnetic pole pieces 15V1 and 15W1 (N pole) of the magnetic poles V1 and W1, respectively. See FIG. 6B. According to this action, at the position of the permanent magnet 7 corresponding to the magnetic pole U2, the strong magnetic force of the magnetic pole U2 urges the permanent magnet 7 downward as viewed in the drawing, and further, to assist the urging force of the magnetic pole U2, the magnetic force weaker than that of the magnetic pole U2, which is generated in the magnetic poles V1 and W2, urges the permanent magnet 7 downward as viewed in the drawing.

Accordingly, at the position where the magnetic pole U1 is located, the fixed gear 5 and the oscillating gear 6 are urged in the direction in which the teeth G1 and G2 mesh with each other at the first position P1 by the urging force of the magnetic poles V2 and W2 in addition to the magnetic pole U1. In addition, at the position where the magnetic pole U2 is located, the oscillating gear 6 and the output gear 4 are urged in the direction in which the teeth G3 and G4 mesh with each other at the second position P2 by the urging force of the magnetic poles V1 and W1 in addition to the magnetic pole U2. Further, at the time point T1, the magnetic force of the magnetic poles V2 and W 2 is weaker than that of the magnetic pole U1, and the magnetic force of the magnetic poles V1 and W1 is weaker than that of the magnetic pole U2, so there is no disturbance to the inclination direction of the oscillating gear 6 and the fixed gear 5, in which the vicinity of magnetic pole U1 is at the highest position and the vicinity of magnetic pole U2 is at the lowest position.

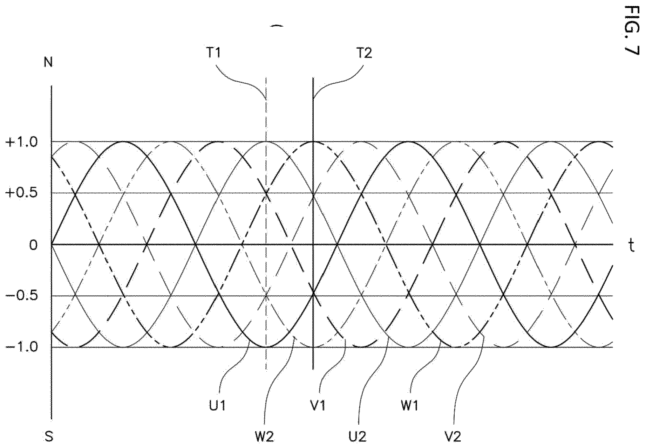

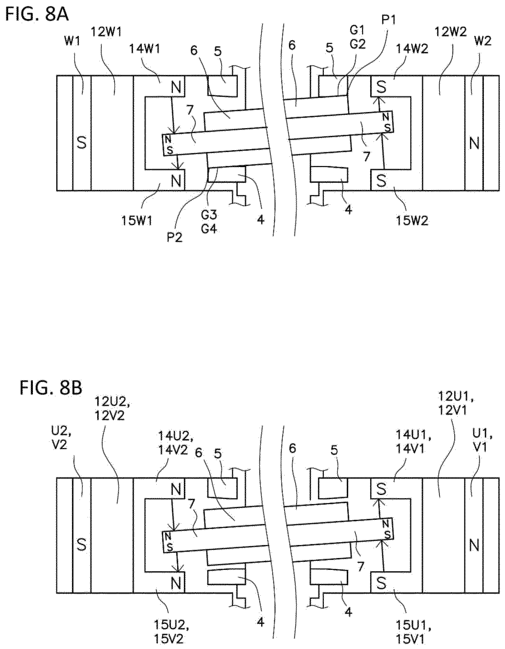

When the control unit 13 continues to supply the sine wave current to each magnetic pole, at the time point T2 when the maximum magnetic force is generated at the magnetic poles W1 and W2, which are disposed at the position rotated clockwise by 60° from the magnetic pole U1 and the magnetic pole U2 (see FIG. 7), the following state will occur. At the position facing the permanent magnet 7 and the magnetic pole W2, the magnetic attraction force is generated between the N pole of the permanent magnet 7 and the upper magnetic pole piece 14W2 (S pole) of the magnetic pole W2, and the magnetic repulsive force is generated between the lower S pole of the permanent magnet 7 and the lower magnetic pole piece 15W2 (S pole) of the magnetic pole W2, thereby urging the position of the permanent magnet 7 corresponding to the magnetic pole W2 upward as viewed in the drawing due to the magnetic force of the magnetic pole W2. See FIG. 8 A. Further, at the position facing the permanent magnet 7 and the magnetic pole W1, the magnetic repulsive force is generated between the upper N pole of the permanent magnet 7 and the upper magnetic pole piece 14W1 (N pole) of the magnetic pole W1, and the magnetic attraction force is generated between the lower S pole of the permanent magnet 7 and the lower magnetic pole piece 15W1 (N pole) of the magnetic pole W1, thereby the position of the permanent magnet 7 corresponding to the magnetic pole W1 of the permanent magnet 7 downward as viewed in the drawing due to the magnetic force of the magnetic pole W1. The magnetic pole U1 and the magnetic pole V1 arranged on both sides of the magnetic pole W2 urge the permanent magnet 7 upward by the magnetic force weaker than that of the magnetic pole W1, and the magnetic pole U2 and the magnetic pole V2 arranged on both sides of the magnetic pole W1 urge the permanent magnet 7 downward by the magnetic force weaker than that of the magnetic pole W1. Thus, the inclination direction of the permanent magnet 7 and the oscillating gear 6 changes by 60° clockwise from the direction of the magnetic poles U1 and U2 to the direction of the magnetic poles W2 and W1, and the permanent magnet 7 is positioned closest to the upper magnetic pole piece of the magnetic pole W2 and the lower magnetic pole piece of the magnetic pole W1.

Further, the magnetic poles U1 and V1 on both sides of the magnetic pole W2 take an S polarity of -0.5, which is smaller than that of the magnetic pole W2, so that the magnetic attraction force is generated between the upper N pole of the permanent magnet 7 and the upper magnetic pole pieces 14U1 and 14V1 (S pole), and the magnetic repulsive force is generated between the lower S pole and the lower magnetic pole piece 15U1, 15V1(S pole) of the permanent magnet 7. Further, the magnetic poles U2 and V2 on both sides of the magnetic pole W1 take an N polarity of +0.5, which is smaller than that of the magnetic pole U2, so that the magnetic repulsive force is generated between the upper N pole of the permanent magnet 7 and the upper magnetic pole pieces 14U2 and 14V2(N pole) of the permanent magnet 7, and the magnetic attraction force is generated between the lower S pole and the lower magnetic pole pieces 15U2 and 15V2(N pole) of the permanent magnet 7.

Accordingly, at the position where the magnetic pole W2 is disposed, the fixed gear 5 and the oscillating gear 6 are urged in the direction in which the teeth G1 and G2 mesh with each other at the first position P1 by the urging force of the magnetic poles U1 and V1 in addition to the magnetic pole W2. In addition, at the position where the magnetic pole W1 is disposed, the oscillating gear 6 and the output gear 4 are urged in the direction in which the teeth G3 and G4 mesh with each other at the second position P2 by the urging force of the magnetic poles U2 and V2 in addition to the magnetic pole W1. Further, at the time point T2, the magnetic force of the magnetic poles U1 and V1 is weaker than that of the magnetic pole W2, and the magnetic force of the magnetic poles U2 and V2 is weaker than that of the magnetic pole W1, so the vicinity of the magnetic pole W1 is the lowest position, and the magnetic poles U1, V1, U2 and V2 do not disturb the inclination direction of the oscillating gear 6 and the fixed gear 5. The magnetic force generated by the electromagnet 8 of the motor section acts in the direction in which the oscillating gear 6 is pressed against the fixed gear 5 and the output gear 4, and backlash is extremely suppressed.

### (Discussion)

As the control unit 13 continues to supply the sine wave current to the coils 12U1, 12U2, 12V1, 12V2, 12W1, and 12W2 as described above, the inclination directions of the permanent magnet 7 and the oscillating gear 6 are displaced clockwise accordingly. Further, when the inclination direction of the oscillating gear 6 rotates clockwise, the first position P1 where the oscillating gear 6 and the fixed gear 5 mesh with each other is displaced clockwise in the circumferential direction with the axis line C1 as the center of rotation. Similarly, the second position P2 where the oscillating gear 6 and the output gear 4 mesh with each other is also displaced clockwise in the circumferential direction with the axis line C1 as the center of rotation. Accordingly, the output shaft 3 rotates and moves at a predetermined speed reduction ratio with respect to the housing 2 with the axis line C1 as the center of rotation. Although the current supplied to the actuator 1 of the present embodiment has been described as a three-phase sine wave current, the present invention is not limited thereto, and the current supplied may vary in size and orientation at a fixed cycle with the lapse of time, and the actuator 1 can operate even if, for example, a rectangular wave in addition to the sine wave. In addition, a known detector such as a hall sensor, an encoder, and a resolver may be provided to detect the rotational position of the output shaft 3.

Further, even if the supply of the current from the control unit 13 is interrupted, the permanent magnet 7 and each of the magnetic poles U1, V1, U2, V2, W1, and W2 are attracted to each other by the magnetic force of the permanent magnet 7, so that the meshed state of the fixed gear 5 and the oscillating gear 6, and the meshed state of the oscillating gear 6 and the output gear 4 are maintained.

Next, the reduction ratio of the fixed gear 5, the oscillating gear 6, and the output gear 4 will be described. The following formula is often used to calculate a reduction ratio R of the reduction gear. R = 1-(n1 × n3)/(n2 × n4). Here, the reduction ratio R can be calculated by n1: the number of teeth of the first gear (fixed gear 5), n2: the number of teeth on the second gear (the side facing the fixed gear 5 of the oscillating gear 6), n3: the number of teeth on the third gear (the side facing the output gear 4 of the oscillating gear 6), and n4: the number of teeth of the fourth gear (the teeth of the output gear 4).

For example, in case the number of teeth of the fixed gear 5 fixed to the housing 2 is set to be 100 and the number of teeth of the fixed gear 5 of the surface facing the fixed gear 5 which is supported rotatably on the output shaft 3 is set to be 101, when the oscillating gear 6 performs a oscillating motion in a clockwise direction relative to the fixed gear 5, the oscillating gear 6 is displaced in the rotational direction from the starting point relative to the fixed gear 5 to the position closer to the starting point, leaving only 1/101 (one tooth) remaining. Further, in case the number of teeth of the oscillating gear 6 of the surface facing the output gear 4 is set to be 100 and the number of teeth of the output gear 4 rotatably attached to the output shaft 3 is set to be 99, when the oscillating gear 6 performs the oscillating motion in the clockwise direction relative to the fixed gear 5 as described above, the output gear 4 is displaced in the rotational direction to a position 1/100 (one tooth) ahead of the oscillating gear 6.

When this is applied to the above calculation formula, n1 = 100, n2 = 101, n3 = 100, and n4 = 99, and the reduction ratio R is - 1/9999. That is, when the oscillating gear 6 rotates once in the clockwise direction, the output shaft 3 moves 1/9999 of a rotation in the counterclockwise direction relative to the housing 2. As described above, the actuator 1 of the present invention can obtain a large reduction ratio by the action of three gears 4, 5, and 6.

In the motor section of the actuator 1 of the present embodiment, an annular permanent magnet 7 is attached to the outer circumference of the oscillating gear 6 such that its upper surface is N-pole and its lower surface is S-pole. The oscillating gear 6 and the annular permanent magnet 7 corresponding to an inner rotor are driven by six magnetic poles U1, U2, V1, V2, W1, and W2 corresponding to an outer stator disposed on the outer circumferential edge of the permanent magnet 7. With the above configuration, the urged force acting on each meshing portion of the oscillating gear 6, which serves as an action point, and the fixed gear 5 and the fixed gear 5 and the output gear 4 can be made larger than that of the outer rotor system. Further, the actuator 1 can be reduced by using the permanent magnet 7 as an inner rotor, and the structure of the inner rotor is also simplified. Therefore, the actuator 1 can obtain a large driving force against a small outer dimension. Other embodiments include the permanent magnet 7 is magnetized so that the upper surface is N-pole and the lower surface is S-pole as in the first embodiment, and four magnetic poles are arranged at intervals of 90° outside the permanent magnet 7, or eight magnetic poles are arranged at intervals of 45° outside the permanent magnet 7.

### (Second Embodiment/Overall Description)

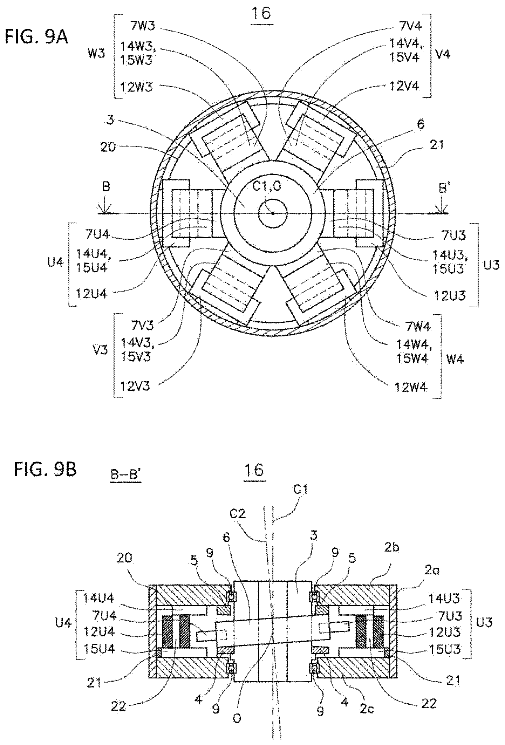

Although the upper magnetic pole pieces 14U1, 14U2, 14V1, 14V2, 14W1, and 14W2 and the lower magnetic pole pieces 15U1, 15U2, 15V1, 15V2, 15W1, and 15W2 take the same polarity in the first embodiment described above, next, an actuator 16 of the second embodiment in which the upper magnetic pole pieces 14U3, 14U4, 14V3, 14V4, 14W3 and 14W4 and the lower magnetic pole pieces 15U3, 15U4, 15V3, 15V4, 15W3 and 15W4 take different polarities will be described. FIG. 9A is a cross-sectional view of the actuator 16 of the present embodiment, and FIG. 9B is a cross-sectional view of the cutting line B-B' shown in FIG. 9A. Since the reducer section of the actuator of the present embodiment has a similar configuration to that of the actuator 1 of the first embodiment, a description thereof will be omitted.

### (Motor Section)

The motor section of the present embodiment includes six permanent magnets 7U3, 7U4, 7V3, 7V4, 7W3 and 7W4 disposed at intervals of 60° radially about a center point O around the outer circumference of the oscillating gear 6, and electromagnets 20 disposed radially at intervals of 60° on the outer circumferences thereof. An electromagnet 20 of the present embodiment is a member formed of a magnetic material such as iron, and includes: a ring 21 formed in an annular shape around an axis line C1; six magnetic poles U3, U4, V3, V4, W3 and W4 protruding from the ring 21 toward the axis line C1; and coils 12U3, 12U4, 12V3, 12V4, 12W3 and 12W4 wound around the magnetic poles U3, U4, V3, V4, W3 and W4, respectively. Further, the magnetic poles U3, U4, V3, V4, W3 and W4 are arranged such that the upper magnetic pole pieces 14U3, 14U4, 14V3, 14V4, 14W3, and 14W4 and the lower magnetic pole pieces 15U3, 15U4, 15V3, 15V4, 15W3, and 15W4 sandwich the permanent magnets 7U3, 7U4, 7V3, 7V4, 7W3 and 7W4 from above and below at intervals that allow the oscillating of the permanent magnets 7U3, 7U4, 7V3, 7V4, 7W3 and 7W4 due to the oscillating of the oscillating gear 6.

The magnetic poles U3, U4, V3, V4, W3 and W4 are connected to the upper magnetic pole pieces 14U1, 14U2, 14V1, 14V2, 14W1 and 14W2 and the lower magnetic pole pieces 15U1, 15U2, 15V1, 15V2, 15W1, and 15W2, which are spaced apart in the vertical direction in the direction of the axis line C1, are each connected by vertical magnetic pole pieces 22, and the coils 12U3, 12U4, 12V3, 12V4, 12W3 and 12W4 are wound around the vertical magnetic pole pieces 22, respectively. The coils 12U3, 12U4, 12V3, 12V4, 12W3 and 12W4 are connected to the control unit 13, and when the control unit 13 sequentially energizes the sin wave shaped current to these coils 12U3, 12U4, 12V3, 12V4, 12W3 and 12W4, the upper magnetic pole pieces 14U1, 14U2, 14V1, 14V2, 14W1 and 14W2 and the opposing lower magnetic pole pieces 15U1, 15U2, 15V1, 15V2, 15W1 and 15W2 generate magnetic forces with different polarities. Thus, a magnetic field is generated in each of the magnetic poles U3, U4, V3, V4, W3 and W 4, and therefore, the permanent magnets 7U3, 7U4, 7V3, 7V4, 7W3 and 7W4 and the oscillating gear 6 are urged upward or downward.

Each of the six permanent magnets 7U3, 7U4, 7V3, 7V4, 7W3 and 7W4 provided in the actuator 16 of the present embodiment is arranged so that the polarity of one magnetic pole is located far from the center point O of the oscillating gear 6, and the polarity of the other magnetic pole is located closer to the center point O. The permanent magnets 7U3, 7U4, 7V3, 7V4, 7W3 and 7W4 arranged at positions rotated by 180° about the center point O are configured to have mutually different polarities. Further, adjacent permanent magnets 7U3, 7U4, 7V3, 7V4, 7W3 and 7W4 are configured to have mutually opposite polarities when a current is sequentially passed through them. For example, if one permanent magnet 7U3 is positioned so that the position closer to the axis line C1 (center side) is S-pole and the position far from the axis line C1 (periphery side) is N-pole, the other permanent magnet 7U4, which is positioned 180° rotated about the axis line C1, is arranged so that the position closer to the axis line C1 (center side) is N-pole and the position far from the axis line C1 (periphery side) is S-pole. The permanent magnet 7U4 is arranged such that the position closer to the axis line C1 (center side) is N-pole and the position far from the axis line C1 (periphery side) is S-pole. In addition, the poles of the permanent magnets 7U3, 7U4, 7V3, 7V4, 7W3 and 7W4, which are arranged adjacent to each other at an interval of 60° in the horizontal direction, are also arranged to have opposite polarities. For example, if the permanent magnet are arranged so that the permanent magnet 7U3 has S-pole at the position closer to the axis line C1 (center side) and N-pole at the position far from the axis line C1 (periphery side), the permanent magnets 7W3 and 7V4, which are arranged at intervals of 60° clockwise and counterclockwise with respect to the permanent magnet 7U3, are arranged so that the position closer to axis line C1 (center side) is N-pole and the position far from axis line C1 (periphery side) is S-pole. The permanent magnets 7U3, 7U4, 7V3, 7V4, 7W3 and 7W4 may be directly fixed to the oscillating gear 6 by a known fixing means, or may be fixed to the oscillating gear 6 through a known fixing member such as a bracket.

### (Rotation of Upper and Lower Attraction Positions/Generation of Rotating Magnetic Field)

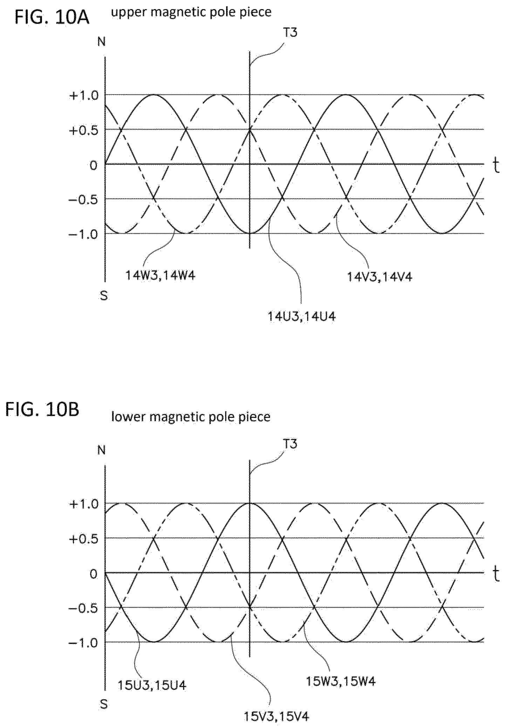

The upper magnetic pole pieces 14U3, 14U4, 14V3, 14V4, 14W3 and 14W4 provided by the actuator 16 rotate attraction position around the axis line C1. Similarly, the lower magnetic pole pieces 15U1, 15U2, 15V1, 15V2, 15W1 and 15W2 also generate a rotating magnetic field such that the rotation and the polarity are opposite to those of the upper attraction position. The electromagnets that generate such a rotating magnetic field may be in any arrangement and configuration. In the present embodiment, as in the first embodiment, the current generated in the sine wave waveform whose magnitude and direction change at regular intervals over time is supplied from the control unit 13. Further, the current supplied from the control unit 13 is a three-phase current, and the current of each phase is supplied to the magnetic pole U3 and the magnetic pole U4, the magnetic pole V3 and the magnetic pole V4, and the magnetic pole W3 and the magnetic pole W4, which are arranged at positions facing each other by 180°, respectively. The current is supplied to the coils 12U3, 12U4, 12V3, 12V4, 12W3 and 12W4 of each magnetic pole. FIG. 14B is a block diagram showing the actuator 16 of the present embodiment, and FIG. 10A is a graph showing changes in the magnetic force of the upper magnetic pole pieces 14U1, 14U2, 14V1, 14V2, 14W1 and 14W2 when a sine wave current is applied to each of the magnetic poles U3, U4, V3, V4, W3 and W4, and FIG. 10B is a graph showing changes in the magnetic force of the lower magnetic pole pieces 15U1, 15U2, 15V1, 15V2, 15W1 and 15W2. In both graphs, the horizontal axis indicates time and the vertical axis indicates the magnitude and pole of the magnetic force. The greater the value of the magnetic pole is than 0, the stronger the magnetic force of the N-pole becomes, and the smaller the value of the magnetic pole is than 0, the stronger the magnetic force of the S-pole becomes. Here, the control unit 13 supplies the same phase current to the magnetic pole U3 and the magnetic pole U4, the same phase current to the magnetic pole V3 and the magnetic pole V4, and the same phase current to the magnetic pole W3 and the magnetic pole W4 among the three-phase current. The coil 12U3 and the coil 12U4, the coil 12V3 and the coil 12V4, and the coil 12W3 and the coil 12W4, which are arranged at positions facing each other by 180°, are wound so that the directions of the magnetic fields are the same when energized, and therefore, the magnetic pole U3 and the magnetic pole U4, the magnetic pole V3 and the magnetic pole V4, and the magnetic pole W3 and the magnetic pole W4 have the same polarity as each other. That is, the motor section of the actuator 16 according to the present embodiment has three-phase coils.

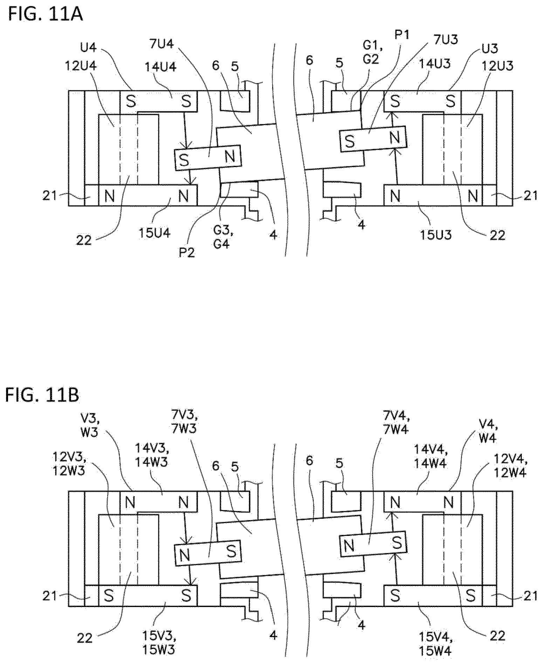

At the time point T3 shown in FIG. 10A and FIG. 10B, the upper magnetic pole pieces 14U3 and 14U4 of the magnetic poles U3 and U4 become S-poles having strong magnetic force of -1.0, and the lower magnetic pole pieces of the magnetic poles U3 and U4 become N-poles having a strong magnetic force of +1.0. The permanent magnet 7U3 is arranged so that the side facing the magnetic pole U3 is an N-pole and the opposite side thereof is an S-pole, and the permanent magnet 7U4 is arranged so that the side facing the magnetic pole U4 is an S-pole and the opposite side thereof is an N-pole. A magnetic attraction force is generated between the permanent magnet 7U3 and the upper magnetic pole piece 14U3 (S-pole) of the magnetic pole U3, and repulsive force due to magnetic force is generated between the permanent magnet 7U3 and the lower magnetic pole piece 15U3 (N-pole) of the magnetic pole U3. See FIG. 11A. Further, since the permanent magnet 7U4 is arranged so that the side facing the magnetic pole U4 becomes an S-pole, the repulsive force due to the magnetic force is generated between the permanent magnet 7U4 and the upper magnetic pole piece 14U4 (S-pole) of the magnetic pole U4, and the magnetic attraction force is generated between the permanent magnet 7U4 and the lower magnetic pole piece 14U4 (S-pole). Therefore, an urging force for moving the permanent magnet 7U4 downward by magnetic force is generated between the permanent magnet 7U4 and the magnetic pole U4. Therefore, the oscillating gear 6, to which the permanent magnets 7U3 and 7U4 are fixed, is urged in the direction of meshing with the fixed gear 5 near the magnetic pole U3 and in the direction of meshing with the output gear 4 near the magnetic pole U4.

At this time T3, the magnetic poles V4 and W4 arranged on both sides of the magnetic pole U3 become N-poles having a small magnetic force of - 0.5 opposite to the polarity of the upper magnetic pole piece of the magnetic pole U3. See FIG. 11B. Since the permanent magnet 7V4 located at a position facing the magnetic pole V4 is arranged so that a side facing the magnetic pole V4 becomes an S-pole, a magnetic attraction force is generated between the permanent magnet 7V4 and the upper magnetic pole piece 14V4 (N-pole) of the magnetic pole V4, and a repulsive force due to magnetic force is generated between the permanent magnet 7V4 and the lower magnetic pole piece 15V4 (S-pole) of the magnetic pole V4. Further, since the permanent magnet 7W4 located at a position facing the magnetic pole W4 is arranged so that the side facing the magnetic pole W4 becomes S-pole, a magnetic attraction force is generated between the permanent magnet 7W4 and the upper magnetic pole piece 14W4 (N-pole) of the magnetic pole W4, and a magnetic repulsive force is generated between the permanent magnet 7W4 and the lower magnetic pole piece 15W4 (S-pole) of the magnetic pole W4. According to this action, the permanent magnet 7U3 is urged upward as viewed in the drawing by the strong magnetic force of the magnetic pole, and further, the permanent magnets 7V4 and 7W4 are urged upward as viewed in the drawing by the weaker magnetic force than that of the magnetic pole U3 generated at the magnetic poles V4 and W4 so as to assist the urging force of the magnetic pole U3. Thus, the oscillating gear 6 is urged upward at positions facing the magnetic poles U3, V4, and W4.

In addition, the upper magnetic pole pieces 14V3 and 14W3 of the magnetic poles V3 and W3 arranged on the both sides of the magnetic pole U4 are N-poles having a small magnetic force of - 0.5 that is opposite to the polarity of the upper magnetic pole piece 14U4 of the magnetic pole U4. The permanent magnet 7V3, which is located opposite the magnetic pole V3, is positioned so that the side facing the magnetic pole V3 is an N-pole, so that a magnetic repulsive force is generated between the permanent magnet 7V3 and the upper magnetic pole piece 14V3 (N-pole) of the magnetic pole V3, and a magnetic attractive force is generated between the permanent magnet 7V3 and the lower magnetic pole piece 15V3 (S-pole). The permanent magnet 7W3 facing the magnetic pole W3 is positioned so that the side facing the magnetic pole W3 is an N-pole, so that a magnetic repulsive force is generated between the permanent magnet 7W3 and the upper magnetic pole piece 14W3 (N-pole) of the magnetic pole W3, and a magnetic attraction force is generated between the permanent magnet 7W3 and the lower magnetic pole piece 15W3 (S-pole). According to this action, the permanent magnets 7V3 and 7W3 are urged downward as viewed in the drawing by the weaker magnetic force that of the magnetic pole U4 generated in the magnetic poles V3 and W3 so as to assist the urging force of the magnetic pole U4 with respect to the permanent magnet 7U4. Thus, the oscillating gear 6 is urged downward at positions facing the magnetic poles U4, V3, and W3.

Therefore, at the position where the magnetic pole U3 is located, the oscillating gear 6 and the fixed gear 5 are urged in a direction in which the teeth G1 and G2 formed on them mesh with each other due to the urging forces of the magnetic poles V4 and W4 in addition to the magnetic pole U3. In addition, at the position where the magnetic pole U4 is located, the oscillating gear 6 and the output gear 4 are urged in a direction in which the teeth G3 and G4 formed on them mesh with each other due to the urging forces of the magnetic poles V3 and W3 in addition to the magnetic pole U4. Further, since the magnetic forces of the magnetic poles V4 and W4 are weaker than that of the magnetic pole U3, and the magnetic forces of the magnetic poles V3 and W3 are weaker than that of the magnetic pole U4, an inclination direction of the oscillating gear 6, whose highest position is near the magnetic pole U3 and whose lowest position is near magnetic pole U4, is not disturbed.

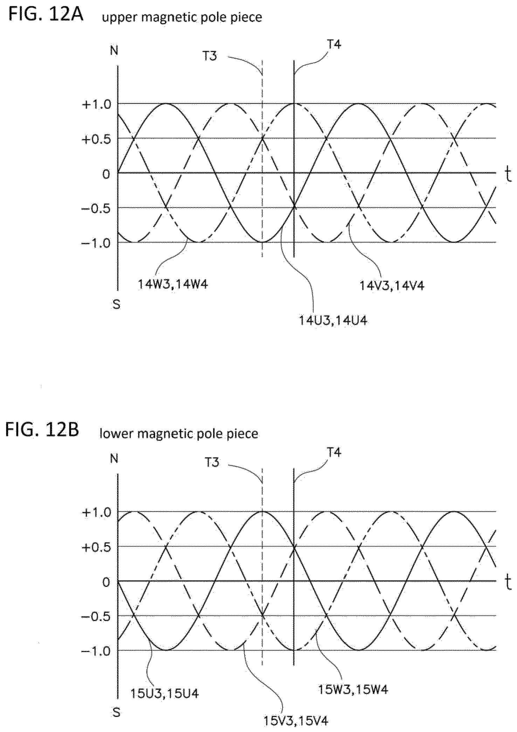

When the control unit 13 continues to supply the sine wave current to each magnetic pole, at the time point T4, the maximum magnetic force is generated in the magnetic poles W3 and W4 which are located at positions rotated 60° clockwise from the magnetic poles U3 and U4. At the time point T4, the upper magnetic pole pieces 14W3 and 14W4 of the magnetic poles W3 and W4 are N-poles having strong magnetic force of +1.0, and the lower magnetic pole pieces 15W3 and 15W4 of the magnetic poles W3 and W4 are S-poles having strong magnetic force of -1.0. See FIGS. 12A and 12B.

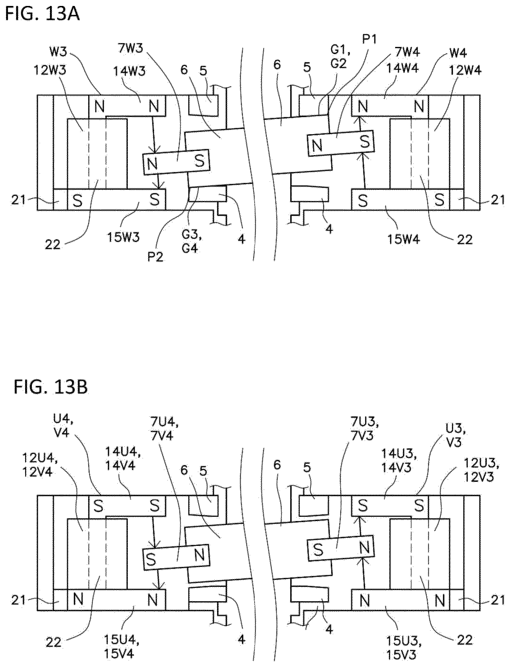

Since the permanent magnet 7W4 is arranged so that the side facing the magnetic pole W4 is S-pole and the opposite side thereof is N-pole, a magnetic attraction force is generated between the permanent magnet 7W4 and the upper magnetic pole piece 14W4 (N-pole) of the magnetic pole W4, and a magnetic repulsive force is generated between the permanent magnet 7W4 and the lower magnetic pole piece 15W4 (S-pole) of the magnetic pole W4. In addition, the permanent magnet 7W3, which is positioned 180° rotated from the permanent magnet 7W4, is arranged so that the side facing the magnetic pole W3 is N-pole and the opposite side is S-pole, so a magnetic repulsive force is generated between the permanent magnet 7W3 and the upper magnetic pole piece 14W3 (N-pole) of the magnetic pole W3 and a magnetic attractive force is generated between the permanent magnet 7W3 and the lower magnetic pole piece 15W3 (S-pole) of the magnetic pole W3. See FIG. 13A.

At this time point T4, the upper magnetic pole pieces 14U3 and 14V3 of the magnetic poles U3 and V3 located on both sides of the magnetic pole W4 are S-poles of a small magnetic force of -0.5 which is opposite to the polarity of the upper magnetic pole piece 14W4 of the magnetic pole W4. The permanent magnets 7U3 and 7V3 facing the magnetic poles U3 and V3, respectively, are arranged so that the sides facing the magnetic poles U3 and V3 are N-poles, so a magnetic attraction force is generated between the permanent magnets 7U3 and 7V3 and the upper magnetic pole pieces 14U3 and 14V3 (S-pole) of the magnetic poles U3 and V3, and a magnetic repulsive force is generated between the lower magnetic pole pieces 15U3 and 15V3 (N pole) of the magnetic pole U3. According to this action, the permanent magnet 7W4 is urged upward as viewed in the drawing due to a strong magnetic force of the magnetic pole W4, and the permanent magnets 7U3 and 7V3 are urged upward as viewed in the drawing due to a magnetic force weaker than that of the magnetic pole W4, which is generated in the magnetic poles U3 and V3, so as to assist the urging force of the magnetic pole W4. Therefore, the oscillating gear 6 is urged upward at the first position P1 facing the magnetic poles W4, V3, and U3. See FIG. 13B.

Similarly, at this time point T4, the upper magnetic pole pieces 14U4 and 14V4 of the magnetic poles U4 and V4 located on both sides of the magnetic pole W3 are S-poles of a small magnetic force of -0.5 which is opposite to the polarity of the upper magnetic pole piece 14W3 of the magnetic pole W3. A magnetic repulsive force is generated between the permanent magnets 7U4 and 7V4 and the upper magnetic pole pieces 14U4 and 14V4 (S-pole) of the magnetic poles U4 and V4, and a magnetic attraction force is generated between the permanent magnets 7U4 and 7V4 and the lower magnetic pole pieces 15U4 and 15V4 (N-pole) of the magnetic poles U4 and V4. According to this action, the permanent magnets 7U4 and 7V4 are urged downward as viewed in the drawing by a magnetic force weaker than that of the magnetic pole W3, which is generated in the magnetic poles U4 and V4, so as to assist the urging force of the magnetic pole W3 with respect to the permanent magnet 7W3. Therefore, the oscillating gear 6 is urged downward at the second position P2 facing the magnetic poles U4, W3, and V4.

Therefore, at the time point T4, at the position where the magnetic pole W4 is located, the oscillating gear 6 and the fixed gear 5 are urged in a direction in which the teeth G1 and G2 formed on them mesh with each other due to the urging forces of the magnetic poles U3 and V3 in addition to the magnetic pole W4. In addition, at the position where the magnetic pole W3 is located, the oscillating gear 6 and the output gear 4 are urged in a direction in which the teeth G3 and G4 formed on them mesh with each other due to the urging forces of the magnetic poles U4 and V4 in addition to the magnetic pole W3. Further, since the magnetic forces of the magnetic poles U3 and V3 are weaker than the magnetic force of the magnetic pole W4 and the magnetic forces of the magnetic poles U4 and V4 are weaker than the magnetic pole W3, the inclination direction of the oscillating gear 6, whose highest position is near the magnetic pole W4 and whose lowest position is near the magnetic pole W3, is not disturbed. When the control unit 13 sequentially energizes each magnetic pole in the clockwise direction as described above, the inclination directions of the permanent magnets and the oscillating gear 6 are displaced clockwise accordingly.

Furthermore, since the inclination direction of the oscillating gear 6 is displaced clockwise, the first position P1 where the oscillating gear 6 and the fixed gear 5 mesh with each other is displaced clockwise with respect to the circumferential direction. Similarly, the second position P2 where the oscillating gear 6 and the output gear 4 mesh with each other is also moved clockwise with respect to the circumferential direction. Therefore, the output shaft 3 rotates with respect to the housing 2 about the axis line C1 at a predetermined speed reduction ratio. Even if the energization from the control unit 13 is interrupted, the permanent magnets 7U3, 7U4, 7V3, 7V4, 7W3 and 7W4 and the magnetic poles U3, U4, V3, V4, W3 and W 4 made of magnetic material are attracted to each other, so the meshed state between the fixed gear 5 and the oscillating gear 6 and the meshed state between the oscillating gear 6 and the output gear 4 are maintained.

### (Consideration)

In the case of the second embodiment, the shapes of the permanent magnets 7U3, 7U4, 7V3, 7V4, 7W3 and 7W4 are formed in the shape of a substantially rectangular parallelepiped block and arranged at angles of 60° to each other, and further, the directions of adjacent permanent magnets 7U3, 7U4, 7V3, 7V4, 7W3 and 7W4 are adjusted so that the poles thereof are opposite to each other. In the above-mentioned arrangement, operation of the actuator 16 causes the oscillating gear 6 to rotate, resulting in a deviation in the positional relationship between the permanent magnets 7U3, 7U4, 7V3, 7V4, 7W3 and 7W4 and the magnetic poles U3, U4, V3, V4, W3 and W4. Therefore, it is desirable to make the number of teeth G2 on the surface of the oscillating gear 6 facing the fixed gear 5 the same as the number of teeth G1 formed on the fixed gear 5 in order to prevent the oscillating gear 6 from rotating. Therefore, even if the permanent magnets and the oscillating gear 6 rock with respect to the fixed gear 5, the permanent magnets and the oscillating gear 6 are not displaced in the rotation direction with respect to the fixed gear 5. Therefore, it is desirable to adjust the reduction ratio R by changing the number of teeth of the oscillating gear 6 and the number of teeth of the output gear 4 meshing with the oscillating gear 6 in the actuator 16 of the second embodiment. Besides, the current supplied to the actuator 16 of the present embodiment is preferably a current whose magnitude and direction change at a fixed cycle over time, and the current waveform is preferably a sine wave or a rectangular wave. Similarly to the first embodiment, a known detector such as a hall sensor, an encoder, or a resolver may be provided to detect the rotational position of the output shaft 3.

In the above-mentioned examples, the directions of adjacent permanent magnets 7U3, 7U4, 7V3, 7V4, 7W3 and 7W4 are adjusted so that their poles are opposite to each other, but they may be the same. In this case, a rotating magnetic field may be created using the magnetic poles U3, U4, V3, V4, W3 and W4, so that the magnetic poles attracting upward and the magnetic poles attracting downward rotate in the same direction with a 180° shift.

Besides, even in the first embodiment, instead of arranging the permanent magnets 7 in an annular shape, a plurality of magnets with the magnetic poles in the vertical direction may be mounted radially on the oscillating gear 6, and the poles of the adjacent permanent magnets may be oriented in opposite directions. In this case, when the rotating magnetic field is generated as in the second embodiment, the oscillating gear 6 can be rocked. In this case, as in the second embodiment, a misalignment will occur in the positional relationship between the permanent magnet 7 and the magnetic poles U1, U2, V1, V2, W1 and W2, so it is desirable to make the number of teeth G2 on the surface of the oscillating gear 6 facing the fixed gear 5 the same as the number of teeth G1 formed on the fixed gear 5.

### (Third Embodiment/Overall Description)

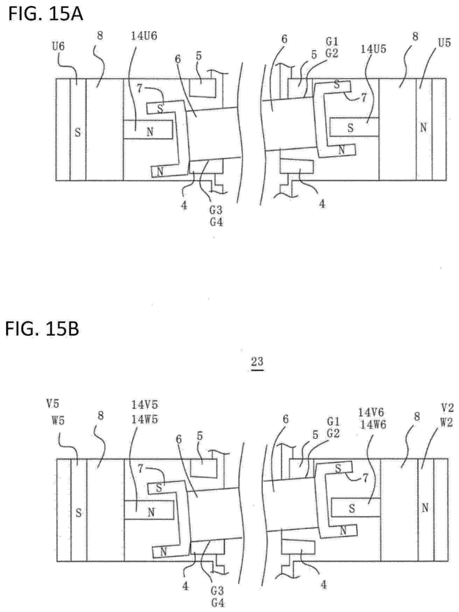

In the actuator 23 of the third embodiment, magnetic forces of the same polarity are generated on the upper and lower sides of the fixed side, and magnetic forces of different polarities are generated on the upper and lower sides of the oscillating side. In the present embodiment, the magnetic poles U5, U6, V5, V6, W5 and W6 of the electromagnet 8 are not branched upward and downward as in the first embodiment, but are composed of single magnetic pole piece 14U5, 14V5, 14W5, 15U6, 15V6 or 15W6 as shown in FIG. 15. On the other hand, the permanent magnets 7 are arranged at intervals so as to sandwich the magnetic pole pieces 14U5, 14V5, 14W5, 15U6, 15V6 and 15W6 so that the upper side is an N magnetic pole and the lower side is an S magnetic pole. Besides, the control of the electromagnet 8 that generates the rotating magnetic field is the same as in the first embodiment, and therefore will not be described here.

In addition, it is possible to arrange magnetic poles that generate magnetic forces with different upper and lower magnetic properties on the fixed side, and to sandwich these magnetic poles on the oscillating side with magnets that generate magnetic forces with the same magnetic properties.

### (Fourth Embodiment)

The actuator 1 of the first embodiment shown in FIG. 3 includes an electromagnet 8 and an electromagnet 20, which are fixed to the housing 2 and arranged around the outer circumference of the annular permanent magnet 7. In the electromagnet 8 of the first embodiment, one of the magnetic poles U1, U2, V1, V2, W1 and W2 of the electromagnet 8 protrudes from the ring 10 toward the oscillating gear 6, and the magnetic poles U1, U2, V1, V2, W1 and W2 are composed of magnetic pole pieces 14U1, 14U2, 14V1, 14V2, 14W1, 14W2, 15U1, 15U2, 15V1, 15V2, 15W1 and 15W2 whose tips are cut into a U-shape and branched upward and downward.

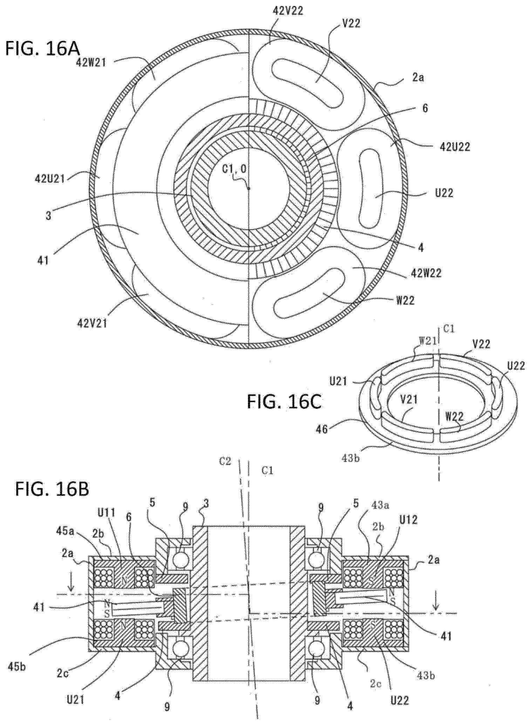

The actuator of the fourth embodiment is configured to have electromagnets 43a and 43b similar to an axial gap type motor with a double stator structure. Besides, the axial gap type motor is a motor having a magnetic gap in the vertical direction, and has the advantage of being thin and having high output compared to a radial gap type motor. In the following description and in FIG. 16, components having the same functions as those in FIG. 3 are given the same reference numerals and descriptions thereof will be omitted.

In FIGS. 16A and 16B, the motor section of the present embodiment includes an annular permanent magnet 41 fixed to the outer circumferential edge of the oscillating gear 6, and electromagnets 43a and 43b arranged above and below the permanent magnet 41. The upper side of the permanent magnet 41 in the direction of the central axis line C1 is an N-pole, and the lower side is an S-pole (the magnetic polarity may be upside down). The permanent magnet 41 may be formed by combining 1/2 and 1/4 arc-shaped magnets.

The electromagnet 43a is arranged on the upper side of the permanent magnet 41 in the direction of the central axis line C1, and the electromagnet 43b is arranged on the lower side of the permanent magnet 41 in the direction of the central axis line C1. Salient pole-shaped magnetic pole pieces U11, U12, V11, V12, W11 and W12 facing the upper surface of the permanent magnet 41 are arranged on a yoke 45a of the electromagnet 43a. Salient pole-shaped magnetic pole pieces U21, U22, V21, V22, W21 and W22 are arranged on a yoke 45b of the electromagnet 43b so as to face the lower surface of the permanent magnet 41. The upper magnetic pole pieces and the lower magnetic pole pieces face the permanent magnet 41 in the vertical direction to form a magnetic gap, and a magnetic force acts in the direction of the central axis line C1.

FIGS. 16A and 16B show the yoke 45b of the electromagnet 43b out of the yokes 45a and 45b of the electromagnets 43a and 43b. Since the yoke 45a of the electromagnet 43a is the same as the yoke 45b of the electromagnet 43b, the description thereof will be omitted. As shown in FIG. 16C, the yoke 45b of the electromagnet 43b is formed by protruding the magnetic pole pieces U21, U22, V21, V22, W21 and W22 in the salient pole shape in the direction of the central axis line C1 from the upper side surface of a base portion 46 formed in an annular shape centered on the central axis line C1 (the yoke 45a has the magnetic pole pieces U11, U12, V11, V12, W11 and W12 protruding from the lower side). Such the yoke 45b is known as a compressed powder magnetic core. The pressed powder magnetic core is a magnetic core made by pressing soft magnetic iron powder into a three-dimensional shape using a mold press, and has supper shape freedom and practical high-frequency characteristics compared to electromagnetic steel sheets. Coils 42U21, 42U22, 42V21, 42V22, 42W21 and 42W22 of the electromagnet 43b are wound on the salient pole-shaped magnetic pole pieces U21, U22, V21, V22, W21 and W22.

A rotating magnetic field in the actuator of the fourth embodiment will be described.

The magnetic pole pieces U21, U22, V21, V22, W21 and W22 on the electromagnet 43b side (and the magnetic pole pieces U11, U12, V11, V12, W11 and W12 on the electromagnet 43a side, not shown, are similarly arranged below and will not be described) are evenly and radially arranged at an angle of 60° around the central axis line C1. Further, the coils 42U21, 42U22, 42V21, 42V22, 42W21 and 42W22 (and the electromagnets 43a-side coils 42U11, 42U12, 42V11, 42V12, 42W11 and 42W12 on the electromagnet 43a side, not shown, are similarly arranged below and will not be described) are wound so that the magnetic pole pieces U21, U22, V21, V22, W21 and W22 located at opposing positions, i.e., positions rotated by 180° around the central axis line C1, become opposite magnetic poles when current is applies. By sequentially energizing each of the coils 42U21, 42U22, 42V21, 42V22, 42W21 and 42W22, the magnetic fields generated in each of the magnetic pole pieces U21, U22, V21, V22, W21 and W22 sequentially change into rotating magnetic fields, causing the permanent magnet 41 to rotate.

The permanent magnet 41, the upper magnetic pole pieces U11, U12, V11, V12, W11, W12, and the lower magnetic pole pieces U21, U22, V21, V22, W21, W22 are attracted to each other in the direction of central axis line C1. The direction of the magnetic attraction force is a direction that presses the meshing of the fixed gear 5 and the oscillating gear 6 and a direction that presses the meshing of the oscillating gear 6 and the output gear 4 (see FIG. 3C). The teeth G2 of the oscillating gear 6 and the teeth G1 of the fixed gear 5, the teeth G3 of the oscillating gear 6, and the teeth G4 of the output gear 4 are pressed against each other vertically at positions shifted by half a circumference due to the magnetic attraction force. That is, contact is maintained between both surfaces of normal rotation side/reverse rotation side of the teeth G2 and G3 of the oscillating gear 6 and both surfaces of normal rotation side/reserve rotation side of the teeth G1 of the fixed gear 5 and the teeth G4 of the output gear 4, so that there is no backlash. Furthermore, since the permanent magnet 41 is attached to the outer circumferential side of the oscillating gear 6, the force pressing the teeth G2 of the oscillating gear 6, the teeth G1 of the fixed gear 5, the teeth G3 of the oscillating gear 6 and the teeth G4 of the output gear 4 on the inner circumferential side acts more strongly.

The teeth of the oscillating gear and the teeth of the output gear, and the teeth of the oscillating gear and the teeth of the fixed gear are pressed against each other at positions shifted by half a circumference due to the magnetic attraction force in the direction of the central axis line, resulting in a state in which backlash is extremely suppressed. When the permanent magnet 41 is rotated by the rotating magnetic field, the first position P1 in which the fixed gear 5 and the oscillating gear 6 mesh with each other is displaced clockwise in the circumferential direction. This movement causes the oscillating gear 6 to rotate relative to the fixed gear 5 by an amount equal to the difference in the number of teeth formed thereon. The second position P2 in which the oscillating gear 6 and the output gear 4 mesh with each other is also moved clockwise in the circumferential direction. This movement causes the output gear 4 to rotate relative to the oscillating gear 6 by an amount equal to the difference in the number of teeth formed thereon. Therefore, the output shaft 3 in which the output gear 4 is fixed also rotates due to the rotation of the output gear 4. That is, due to the rotation of the permanent magnet 41, the output shaft 3 is rotationally moved relative to the housing 2 along a reduction ratio composed of the fixed gear 5, the oscillating gear 6, and the output gear 4.

### (Modification of the Fourth Embodiment)

In the actuator 16 of the second embodiment shown in FIG. 9, the electromagnet 20 is arranged on the outer circumference of the permanent magnet 7 as in the first embodiment, but unlike the first embodiment, the electromagnet 20 is arranged in such a way that the upper magnetic pole pieces 14U3, 14U4, 14V3, 14V4, 14W3, 14W4 and the lower magnetic pole pieces 15U3, 15U4, 15V3, 15V4, 15W3, 15W4 sandwich the permanent magnets 7U3, 7U4, 7V3, 7V4, 7W3 from above and below, with an interval that allows the permanent magnets 7U3, 7U4, 7V3, 7V4, 7W3 to rock due to the oscillating of the oscillating gear 6. Each of the permanent magnets 7U3, 7U4, 7V3, 7V4, 7W3, and 7W4 has an N-pole on the side closer to the central axis line C1, and an S-pole on the side farther from the central axis line C1 (the magnetic polarity may be reversed).

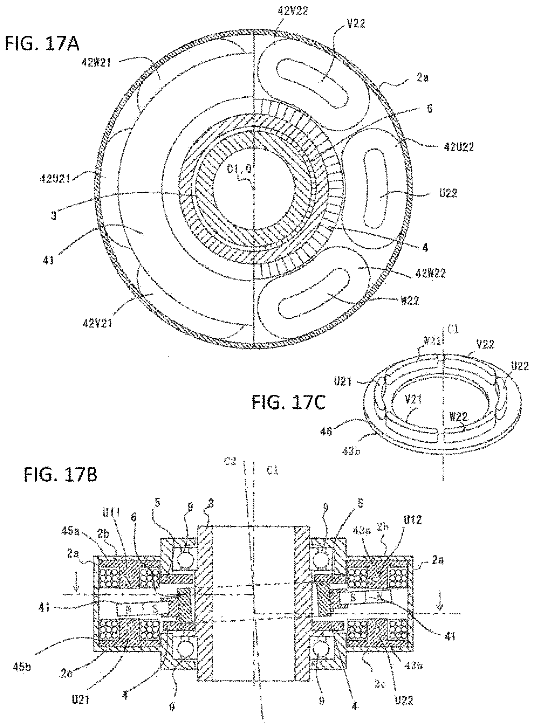

In a modification example of the actuator of the fourth embodiment shown in FIG. 17, similarly to the actuator 16 of the second embodiment shown in FIG. 9, each of the permanent magnets 14 has an N-pole on the side closer to the central axis line C1, and an S-pole on the farther side (the magnetic polarity may be reversed). In the modified example of the fourth embodiment, an arc-shaped permanent magnet 41 is used instead of discrete magnets such as permanent magnets 7U3, 7U4, 7V3, 7V4, 7W3, and 7W4 in FIG. 9. However, the permanent magnet 41 may be formed by combining 1/2 or 1/4 arc-shaped magnets, or by arranging discrete magnets in an arc shape.

A rotating magnetic field in the modified example of the fourth embodiment will be described.

The difference between the fourth embodiment and its modified example is that in the fourth embodiment, the polarities of the magnetic pole pieces U21, U22, V21, V22, W21 and W22 on the electromagnet 43b side and the magnetic pole pieces U11, U12, V11, V12, W11 and W12 on the electromagnet 43a side that face each other are made to be the same, whereas in the modified example, they are made to be different. On the other hand, as similar to the fourth embodiment in the modified example, coils 42U21, 42U22, 42V21, 42V22, 42W21, 42W22, and coils 42U11, 42U12, 42V11, 42V12, 42W11, 42W12 are all wound so that the magnetic poles at opposing positions, i.e., positions rotated 180° around the central axis line C1, become opposite magnetic poles when current is applied.

### (Workpiece Transfer Robot)

Next, embodiments of the workpiece transfer robot 32 using the actuators 1, 16, and 23 of the present invention will be described. FIG. 16 is a cross-sectional view showing the workpiece transfer robot 32 using the actuators 1, 16, and 23. The workpiece transfer robot 32 is a horizontal articulated robot, and includes a base 33, a first arm 34, a second arm 35, a finger 36, and a lifting mechanism 37. The lifting mechanism 37 is provided on the base 33, and moves the first arm 34 up and down by a known driving means. The base end of the first arm 34 is rotatably attached to the lifting mechanism 37 through a bearing (not illustrated), and the base end of the second arm 35 is rotatably attached to the tip of the first arm 34 through a bearing (not illustrated). The base end of the finger 36 holding the workpiece is rotatably attached to the tip of the second arm 35 through a bearing (not illustrated). Here, the first arm 34 is configured to be rotatable in a horizontal plane with the axis C 1-1 as a rotation center, and the second arm 35 is configured to be rotatable in a horizontal plane with the axis C 1-2 as a rotation center, and the finger 36 is configured to be rotatable in a horizontal plane with the central axis line C 1-3 as a rotation center.

The workpiece transfer robot 32 according to the present embodiment includes any of the actuators 1, 16, and 23 as a drive source for individually rotating the first arm 34, the second arm 35, and the finger 36 in the horizontal direction. The actuators 1, 16, and 23 for driving the first arm 34 have their housing 2 fixed to the lifting mechanism 37, and the base end of the first arm 34 is fixed to the output shaft 3. Further, the first arm 34 is arranged so that the axis line C1 of the actuators 1, 16, and 23 and the rotation axis line C1-1 of the first arm 34 coincide with each other. The actuators 1, 16, 23 for driving the second arm 35 are disposed in the internal space of the tip of the first arm 34, the housing 2 is fixed to the first arm 34, and the base end of the second arm 35 is fixed to the output shaft 3. Further, the second arm 35 is arranged so that the axis line C1 of the actuators 1, 16, and 23 and the rotation axis line C1-2 of the second arm 35 coincide with each other. Furthermore, the actuators 1, 16, 23 for driving the fingers 36 are arranged in the internal space of the tip of the second arm 35, the housing 2 is fixed to the second arm 35, and the base end of the finger 36 is fixed to the output shaft 3. The fingers 36 are arranged so that the axis line C1 of the actuators 1, 16, and 23 and the rotation axis line C1-3 of the fingers 36 coincide with each other.

The actuators 1, 16, 23 for driving the first arm 34, the second arm 35, and the finger 36 are individually controlled by the control unit 13. Further, a known Hall sensor, an encoder, a resolver, and a detection sensor are provided as detection means for detecting the rotational positions of the first arm 34, the second arm 35, and the finger 36. With the above configuration, the rotation positions and the rotation speeds of the first arm 34, the second arm 35, and the finger 36 are individually controlled by the control unit 13, and the workpiece held on the finger 36 can be delivered to a predetermined position.

By using the actuators 1, 16, and 23 of the present invention as the drive source of the workpiece transfer robot 32, the weight of the tip portions of the arms 34 and 35 can be significantly reduced in weight compared to those using a known motor or a speed reducer. Further, the actuators 1, 16, 23 of the present invention have a smaller thickness dimension than known motors and reducers by arranging the reducer section and motor section in the radial direction, so that the vertical dimension of each arm 34, 35 can be reduced. Furthermore, by arranging the speed reducer section and the motor section in the radial direction with the output shaft 3, which serves as the drive shaft, at the center, the output shaft 3 can be formed in a hollow shape, and members such as electric wiring 38 and piping required for the operation of each arm 34, 35 and finger 36 can be easily passed through it. Further, since the large reduction ratio can be obtained regardless of the relatively small outer dimension, the positioning accuracy of each arm 34, 35 and finger 36 is improved, therefore, the transfer accuracy of the workpiece transfer robot 32 can be improved.

In each of the embodiments described above, the current waveform supplied by the control unit 13 to each motor section is a sine wave, but the present invention is not limited this, and, for example, it is also possible to supply the current as a trapezoidal waveform, or the motor section may be driven in microsteps. In each of the above embodiments, three-phase excitation is used, but another excitation such as two-phase, four-phase, five-phase, six-phase, eight-phase, etc. may also be used. Although the actuator according to the present invention has been described on the basis of the embodiments, the present invention is not limited to the above-described embodiments, and various modifications can be made within a range in which the gist of the present invention is not changed.

### DESCRIPTION OF THE REFERENCE NUMERAL

1, 16, 23 actuator
2 housing
2a housing body
2b upper housing
2c lower housing
3 output shaft
4 output gear
5 fixed gear
6 oscillating gear
7 permanent magnet
7U3, 7U4, 7V3, 7V4, 7W3, 7W4 permanent magnet
8, 20 electromagnet
10, 21 ring
12U1, 12U2, 12U3, 12U4, 12V1, 12V2, 12V3, 12V4, 12W1, 12W2, 12W3, 12W4 coil
13 control unit
14U1, 14U2, 14U3, 14U4, 14V1, 14V2, 14V3, 14V4, 14W1, 14W2, 14W3, 14W4 upper magnetic pole piece
15U1, 15U2, 15U3, 15U4, 15V1, 15V2, 15V3, 15V4, 15W1, 15W2, 15W3, 15W4 lower magnetic pole piece
14U5, 14V5, 14W5, 15U6, 15V6, 15W6 magnetic pole piece
16 actuator
22 vertical magnetic pole piece
32 workpiece transfer robot
33 base
34 first arm
35 second arm
36 finger
37 lifting mechanism
38 electrical wiring
39 movement restricting protrusion
40 bearing
41 permanent magnet
42U11, 42U12, 42U21, 42U22 coil
43a, 43b electromagnet
44 support ring
45a, 45b yoke
46 base portion
A-A, B-B cut line
C1 axis
C 2 inclined central axis line
G1, G2, G3, G4 teeth
O center point
P1 first position
P2 second position
U1, U2, U3, U4, U5, U6, V1, V2, V3, V4, V5, V6, W1, W2, W3, W4, W5, W6 magnetic pole

## Claims

1. An actuator comprising:
a housing pivotally supporting an output shaft whose axial direction is in a vertical direction;
an output gear rotating with the output shaft;
a fixed gear fixed to the housing and provided facing the output gear;
a oscillating gear arranged between the output gear and the fixed gear, a first teeth provided on a surface of the fixed gear side meshing with the fixed gear, and a second teeth provided on a surface of the output gear side meshing with the output gear;
a permanent magnet fixed concentrically to the oscillating gear on an outer circumferential side of the oscillating gear,
a plurality of electromagnets fixed to the housing concentrically with the output shaft, having upper magnetic pole piece and lower magnetic pole piece facing an upper surface and a lower surface of the permanent magnet in a vertical direction so as not to come into contact with the permanent magnet oscillating due to rock of the oscillating gear, and the upper magnetic pole piece and the lower magnetic pole piece, and the upper and lower surfaces of the permanent magnet forming a magnetic gap in the vertical direction,
wherein the electromagnet is controlled so that the upper magnetic pole piece and the upper surface of the permanent magnet, and the lower magnetic pole piece and the lower surface of the permanent magnet act in a direction in which the first teeth of the oscillating gear is pressed against the teeth of the fixed gear at a first position, and act in a direction in which the second teeth of the oscillating gear against the teeth of the output gear at a second position of half around a circumference from the first position.

2. The actuator as claimed in claim 1,
wherein the permanent magnet is fixed concentrically to the oscillating gear such that the upper side becomes one polarity and the lower side becomes the other polarity, and
wherein the plurality of electromagnets have same magnetic poles on the upper magnetic pole piece and the lower magnetic pole piece, and magnetic attraction force generated by the permanent magnet sandwiched therebetween having different polarities on the upper surface and the lower surface acts in a direction of pushing the first teeth of the oscillating gear against the teeth of the fixed gear in the first position, and acts in a direction of pushing the second teeth of the oscillating gear against the teeth of the output gear at the second position of half around a circumference from the first position.

3. The actuator as claimed in claim 1,
wherein the permanent magnet is arranged on an outer circumferential side of the oscillating gear with one magnetic pole facing the outer circumferential side from a center point of the oscillating gear, and
wherein the plurality of electromagnets have different magnetic poles on the upper magnetic pole piece and the lower magnetic pole piece, and magnetic attraction force generated by the permanent magnet sandwiched therebetween having the one magnetic pole acts in a direction of pushing the first teeth of the oscillating gear against the teeth of the fixed gear in the first position, and acts in a direction of pushing the second teeth of the oscillating gear against the teeth of the output gear at the second position of half around a circumference from the first position.

4. The actuator as claimed in claim 1,
wherein the first teeth and the second teeth of the oscillating gear, the teeth of the fixed gear, and the teeth of the output gear are formed radially from the center position of each of the gears and are formed so as to become deeper as they move away from the center position.

5. The actuator as claimed in claim 1,
wherein a waveform of forward and reverse currents is a sine wave.

6. The actuator as claimed in claim 1,
wherein a waveform of forward and reverse currents is a rectangular wave.

7. The actuator as claimed in claim 1,
wherein the plurality of electromagnets are arranged at equal intervals on a circumference centered on the axis, and the electromagnets arranged at positions facing 180° in a plan view are configured to be provided with the same phase current and direct opposite polarities to the oscillating gear.

8. The actuator as claimed in claim 2,
wherein the permanent magnets are an even number of permanent magnets arranged at equal intervals on a circumference centered on the central axis line.

9. The actuator as claimed in claim 8,
wherein adjacent permanent magnets are arranged so as to have opposite polarities each other, and the number of first teeth of the oscillating gear is the same as the number of teeth of the fixed gear.

10. The actuator as claimed in claim 1,
wherein the electromagnets are arranged on the upper and lower sides of the permanent magnet in a vertical direction respectively, and the magnetic pole pieces of each electromagnet are formed so as to protrude upward from the upper surface of the annular base portion in a projecting pole shape.

11. An actuator comprising:
a housing pivotally supporting an output shaft whose axial direction is in a vertical direction;
an output gear rotating with the output shaft;
a fixed gear fixed to the housing and provided facing the output gear;
a oscillating gear arranged between the output gear and the fixed gear, a first teeth provided on a surface of the fixed gear side meshing with the fixed gear, and a second teeth provided on a surface of the output gear side meshing with the output gear;
a permanent magnet fixed to the housing concentrically around the output shaft surrounding the outer circumference of the oscillating gear, and fixed to the outer circumference of the oscillating gear with both polarities spaced apart such that one magnetic pole is on the upper side and the other magnetic pole is on the lower side,
a plurality of electromagnets arranged concentrically around the oscillating gear on the outer circumference of the oscillating gear, with one magnetic pole facing the permanent magnet sandwiched between the both magnetic poles of the permanent magnet,
wherein a magnetic attraction force generated by each electromagnet having one magnetic pole and the permanent magnets above and below having different magnetic poles acts in a direction pressing first teeth of the oscillating gear against teeth of the fixed gear at a first position, and acts in a direction pressing second teeth of the oscillating gear against teeth of the output gear at a second position half away around a circumference.

12. A workpiece transfer robot comprising:
an arm body to which a plurality of arms are connected so as to be rotatable about their respective central axis lines;
a finger rotatably attached to the tip of the arm body, and
an actuator according to any one of claims 1 and 11 that rotates the plurality of arms and the finger.
